# EUROPEAN PATENT APPLICATION

(11) **EP 4 797 787 A1**
(43) Date of publication of application: **26.08.2026**
(21) Application number: 24893254.3
(22) Date of filing: 07.11.2024
(51) Int. Cl.: H04W 28/06

(54) **SENSING DATA TRANSMISSION METHOD AND APPARATUS**

(30) Priority: 20.11.2023 CN 202311555347
(71) Applicant: HUAWEI TECHNOLOGIES CO., LTD., Shenzhen 518129 (CN)
(72) Inventor: XIE, Junwen, Shenzhen, Guangdong 518129 (CN); MA, Mengyao, Shenzhen, Guangdong 518129 (CN); XIAO, Yao, Shenzhen, Guangdong 518129 (CN); LIU, Kai, Shenzhen, Guangdong 518129 (CN)
(74) Representative: Gill Jennings & Every LLP
(86) International application number: PCT/CN2024/130495
(87) International publication number: WO 2025/108096

(57) **Abstract**

This application relates to the field of communication technologies, and in particular, to a sensing data transmission method and an apparatus, to improve compression flexibility for sensing data, achieve higher compression efficiency, and reduce the amount of sensing data. The method includes: generating, by a first communication apparatus, compressed data and first indication information, where the first indication information indicates categories of multiple pieces of sensing data, the compressed data is obtained by compressing the multiple pieces of sensing data using compression schemes corresponding to their respective categories, and sensing data of the same category among the multiple pieces of sensing data corresponds to the same compression scheme in a correspondence between different categories of sensing data and different compression schemes; and sending the compressed data and the first indication information to a second communication apparatus.

## Description

### CROSS-REFERENCE TO RELATED APPLICATIONS

This application claims priority to Chinese Patent Application No. 202311555347.8, filed with the China National Intellectual Property Administration on November 20, 2023 and entitled "SENSING DATA TRANSMISSION METHOD AND APPARATUS", which is incorporated herein by reference in its entirety.

### TECHNICAL FIELD

Embodiments of this application relate to the field of communication technologies, and in particular, to a sensing data transmission method and an apparatus.

### BACKGROUND

With increasingly rich application scenarios of wireless communication, wireless communication systems may be applied to more new scenarios such as sensing, point cloud, imaging, and environment reconstruction. For example, in environment reconstruction, a plurality of terminal devices may scan the environment, and send collected sensing data to a base station, and the base station may construct a complete environment map based on the received sensing data.

In scenarios such as environment reconstruction, transmitting a large amount of sensing data is required. Therefore, how to compress the sensing data to reduce the amount of data is critical challenge.

### SUMMARY

This application provides a sensing data transmission method and an apparatus to improve compression flexibility for sensing data, achieve higher compression efficiency, and reduce the amount of sensing data.

According to a first aspect, an embodiment of this application provides a sensing data transmission method. The method may be performed by a first communication apparatus, and the method includes: generating compressed data and first indication information, where the first indication information indicates categories of a plurality of pieces of sensing data, the compressed data is obtained by compressing the plurality of pieces of sensing data according to compression schemes corresponding to the categories of the plurality of pieces of sensing data, and sensing data of a same category among the plurality of pieces of sensing data corresponds to a same compression scheme in a correspondence between different categories of sensing data and different compression schemes; and sending the compressed data and the first indication information to a second communication apparatus.

For example, the categories of the plurality of pieces of sensing data may be determined based on categories of target objects corresponding to the plurality of pieces of sensing data.

In the foregoing sensing data transmission method, the first communication apparatus and the second communication apparatus are different communication apparatuses. The first communication apparatus (or the second communication apparatus) may be a terminal device, an internal component (for example, a processor, a chip, or a chip system) of a terminal device, or an apparatus that matches a terminal device; or may be a network device, an internal component (for example, a processor, a chip, or a chip system) of a network device, or an apparatus that matches a network device.

According to the foregoing method, it is considered that importance and features of different categories of sensing data may be different. In this case, different compression schemes may be set for the different categories of sensing data. This helps improve compression flexibility for sensing data, achieve higher compression efficiency, and reduce the amount of sensing data.

In a possible design, the correspondence between the different categories of the sensing data and the different compression schemes includes: one or more of a compression scheme for performing quantization compression on sensing data without sampling; a compression scheme for performing quantization compression on sensing data with sampling; a compression scheme for performing compression based on a geometric structure corresponding to sensing data; a compression scheme for performing compression based on a bounding box corresponding to sensing data; or a compression scheme based on geometric projection of sensing data. In this design, different compression schemes may be set for different categories of sensing data. This helps improve compression flexibility for sensing data and achieve higher compression efficiency.

For example, in the compression scheme for performing quantization compression on the sensing data without sampling, quantization compression without sampling may represent that quantization compression is performed on all data.

In the compression scheme for performing quantization compression on the sensing data with sampling, sampling may be extracting a part of data, for example, extracting a part of data in a form of data downsampling/feature data extraction, and the like, and quantization compression with sampling may represent that quantization compression is performed on the part of extracted data.

In the compression scheme for performing compression based on the geometric structure corresponding to the sensing data, the geometric structure may be a structure, for example, a plane, a curved surface, a polygon, a polyhedron, a cube, a cylinder, or a cone. Specifically, compression may be performed in the following manner: (1) Geometric structure information is used to replace original data, where the compressed data includes the geometric structure information, for example, the original data is replaced with a cylinder, and the compressed data may include a center point, a radius, and a height of the cylinder, or the original data is replaced with a polygon, and the compressed data may include a vertex and the like of the polygon; or (2) data compression is performed based on geometric structure information, where the compressed data may include the geometric structure information and/or sensing data information included in a geometric structure, for example, all/a part of sampled sensing data in a geometric structure scanning area. In addition, it may be understood that entropy encoding, or quantization and entropy encoding may be further performed on the foregoing compressed data, to further reduce a data amount.

In the compression scheme for performing compression based on the bounding box corresponding to the sensing data, the bounding box may be a bounding box of a target (a vehicle/person/object, or the like), and there may be a plurality of forms of the bounding box, for example, a minimum bounding box or a bounding box based on a xyz three-axis. Specifically, compression may be performed in the following manner: (1) Bounding box information is used to replace original data, where the compressed data includes the bounding box information, and the bounding box information may be a vertex of the bounding box, or a central location and a length of the bounding box; or (2) data compression is performed based on bounding box information, where the compressed data includes the bounding box information and/or data included in the bounding box, for example, all target data/a part of sampled target data (such as a target feature point and a contour point) in the bounding box. In addition, it may be understood that entropy encoding, or quantization and entropy encoding may be further performed on the foregoing compressed data, to further reduce a data amount. A boundary of quantization may be a data range, or may be a bounding box range. For example, the boundary of quantization may be a boundary of the sensing data based on a xyz three-axis coordinate system, or may be a coordinate system whose axes are a length, a width, and a height of the bounding box and into which the sensing data is converted. Based on the boundary of the coordinate system, if the coordinate system based on conversion is used, a coordinate system conversion relationship, for example, a translation vector and/or a rotation parameter, needs to be sent to the second communication apparatus (for example, a base station), where the rotation parameter may be a rotation matrix, a three-axis rotation angle, or the like.

In the compression scheme based on geometric projection of the sensing data, dimension reduction compression may be performed on data obtained by projecting the sensing data based on spherical coordinates/polar coordinates/Descartes coordinates. For example, two dimensions of the obtained data are used as position information, and remaining dimension data is compressed. This manner may be used for all data/a part of data, may be used for geometric structure information and/or data included in a geometric structure, and may be used for target bounding box information and/or data included in a bounding box.

In a possible design, any piece of sensing data includes multi-dimensional data, the first indication information further indicates position information of the plurality of pieces of sensing data, and position information of any piece of sensing data is determined based on two-dimensional data in the multi-dimensional data in the sensing data. In this design, the first indication information may indicate the two-dimensional data in the sensing data, and only data other than the two-dimensional data that corresponds to the position information and that is in the sensing data needs to be compressed, thereby further reducing a data amount of the obtained compressed data.

In a possible design, the plurality of pieces of sensing data are of a first category; and generating the compressed data includes: performing quantization compression on third-dimensional data of the plurality of pieces of sensing data to obtain quantized compressed data, where third-dimensional data of any piece of sensing data is data in the multi-dimensional data in the sensing data other than the two-dimensional data that corresponds to the position information. In this design, compression processing may be performed in a quantization compression scheme, to further reduce a data amount of the generated compressed data.

In a possible design, the multi-dimensional data in any piece of sensing data includes at least three of θ, φ, R, x, y, z, r, θ represents a vertical angle in a spherical coordinate system, φ represents a horizontal angle in the spherical coordinate system, R represents a distance to an origin in the spherical coordinate system, x represents an abscissa in a Cartesian coordinate system, y represents an ordinate in the Cartesian coordinate system, z represents a vertical coordinate in the Cartesian coordinate system, r represents a projected distance on a horizontal plane in the Cartesian coordinate system, and the third-dimensional data in the plurality of pieces of sensing data other than the two-dimensional data that corresponds to the position information is selected based on an information entropy or a value range of each dimension of data in the multi-dimensional data other than the two-dimensional data. In this design, a data dimension for compression may be selected based on the information entropy or the value range, thereby helping achieve higher compression efficiency.

In a possible design, the plurality of pieces of sensing data are of a second category, and generating the compressed data includes: determining, based on the plurality of pieces of sensing data, geometric structure parameters or geometric structure identification points of at least one geometric structure (for example, a plane, a curved surface, a polygon, a polyhedron, a cube, a cylinder, or a cone) in which the plurality of pieces of sensing data are located, where the first indication information further indicates a geometric structure in which the plurality of pieces of sensing data are located, geometric structure parameters or geometric structure identification points of any geometric structure are used to determine the geometric structure, and the geometric structure identification points may be boundary points of the geometric structure, concave area points and/or convex area points located in the geometric structure, or the like. For example, when the sensing geometric structure is a plane, the geometric structure identification points may be three points that are not on a same straight line but are located on the plane, or the like. In this design, only the geometric structure parameters or the geometric structure identification points may be sent, to obtain a larger compression gain.

In a possible design, the method further includes: performing quantization compression on residuals corresponding to the plurality of pieces of sensing data to obtain quantized compressed data, where the residuals corresponding to the plurality of pieces of sensing data are determined based on the plurality of pieces of sensing data and a plurality of pieces of restored data corresponding to the plurality of pieces of sensing data, and restored data corresponding to any piece of sensing data is determined based on position information of the sensing data and a geometric structure in which the sensing data is located. In this design, residual data is further transmitted, so that a performance requirement of high reconstruction precision of the sensing data can be met.

In a possible design, the plurality of pieces of sensing data are of a third category, and generating the compressed data includes: determining at least one bounding box corresponding to the plurality of pieces of sensing data, where the first indication information further indicates a bounding box in which the plurality of pieces of sensing data are located; and performing quantization compression on bounding box endpoints of the plurality of pieces of sensing data and/or sensing data located at the bounding box endpoints to obtain quantized compressed data; or performing quantization compression on third-dimensional data of a plurality of pieces of sensing data located in any bounding box to obtain quantized compressed data, where third-dimensional data of any piece of sensing data is data in the multi-dimensional data in the sensing data other than the two-dimensional data that corresponds to the position information.

For example, performing quantization compression on the third-dimensional data of the plurality of pieces of sensing data located in any bounding box, to obtain the quantized compressed data includes: performing quantization compression on the bounding box endpoints (for example, three-dimensional data of the bounding box endpoints or third-dimensional data of the bounding box endpoints) of the plurality of pieces of sensing data and/or third-dimensional data of the sensing data located at the bounding box endpoints to obtain quantized compressed data; or performing quantization compression on third-dimensional data of a plurality of pieces of sampled sensing data among the plurality of pieces of sensing data to obtain quantized compressed data, where a quantity of the plurality of pieces of sampled sensing data is less than a quantity of the plurality of pieces of sensing data, or performing quantization compression on third-dimensional data of all the sensing data located in the bounding box to obtain quantized compressed data. In this design, sampled sensing data (feature points) may be selected for compression, to obtain compressed data, and other sensing data is restored through interpolation, so that compression efficiency can be further improved.

In a possible design, the method further includes: receiving a compression configuration from the second communication apparatus, where the compression configuration indicates one or more categories of sensing data to be transmitted, and the categories of the plurality of pieces of sensing data belong to the categories of the sensing data to be transmitted that are indicated by the compression configuration. In this design, only compressed data of a category required by the second communication apparatus can be transmitted, thereby further reducing a data transmission amount.

In a possible design, the compression configuration further indicates a compression parameter and/or compression performance respectively corresponding to the one or more categories of sensing data to be transmitted, where the compressed data meets a requirement of the compression parameter and/or the compression performance. This design helps the second communication apparatus adjust a compression parameter and/or compression performance on a first communication apparatus side based on a requirement on performance of the sensing data.

In a possible design, the compression configuration further indicates transmission priorities respectively corresponding to the one or more categories of the sensing data to be transmitted, and the compressed data and the first indication information are sent to the second communication apparatus based on transmission priorities corresponding to the categories of the plurality of pieces of sensing data. In this design, in scenarios such as a resource limitation scenario, the first communication apparatus may preferentially send data required by the second communication apparatus based on transmission priorities corresponding to categories of sensing data to be transmitted and through layer-based data transmission or level-based data transmission.

In a possible design, the compressed data further includes reconstruction performance of the plurality of pieces of sensing data; and the method further includes: receiving second indication information from the second communication apparatus, where the second indication information indicates to send residuals corresponding to the plurality of pieces of sensing data, and the second indication information is sent by the second communication apparatus when the reconstruction performance does not meet a reconstruction performance threshold; and sending the residuals corresponding to the plurality of pieces of sensing data to the second communication apparatus, where the residuals corresponding to the plurality of pieces of sensing data are determined based on the plurality of pieces of sensing data and a plurality of pieces of restored data corresponding to the plurality of pieces of sensing data, and restored data corresponding to any piece of sensing data is determined based on position information corresponding to the sensing data and a geometric structure in which the sensing data is located. In this design, the residual data may be sent only when the second communication apparatus delivers an indication, and a performance requirement of high reconstruction precision of the sensing data can be met when a specific compression gain is obtained.

According to a second aspect, an embodiment of this application provides a sensing data transmission method. The method may be performed by a second communication apparatus, and the method includes: receiving compressed data and first indication information from a first communication apparatus, where the first indication information indicates categories of a plurality of pieces of sensing data, the compressed data is obtained by compressing the plurality of pieces of sensing data according to compression schemes corresponding to the categories of the plurality of pieces of sensing data; and generating the plurality of pieces of sensing data, where the plurality of pieces of sensing data are obtained by decompressing the compressed data in decompression schemes corresponding to the categories of the plurality of pieces of sensing data, and sensing data of a same category among the plurality of pieces of sensing data corresponds to a same decompression scheme in a correspondence between different categories of sensing data and different decompression schemes.

For example, the categories of the plurality of pieces of sensing data are determined based on categories of target objects corresponding to the plurality of pieces of sensing data.

In a possible design, the correspondence between the different categories of the sensing data and different compression schemes includes: one or more of a compression scheme for performing quantization compression on sensing data without sampling; a compression scheme for performing quantization compression on sensing data with sampling; a compression scheme for performing compression based on a geometric structure corresponding to sensing data; a compression scheme for performing compression based on a bounding box corresponding to sensing data; or a compression scheme based on geometric projection of sensing data.

In a possible design, any piece of sensing data includes multi-dimensional data, the first indication information further indicates position information of the plurality of pieces of sensing data, and position information of any piece of sensing data is determined based on two-dimensional data in the multi-dimensional data in the sensing data; and the plurality of pieces of sensing data are obtained by decompressing the compressed data based on the decompression schemes corresponding to the categories of the plurality of pieces of sensing data and the position information of the plurality of pieces of sensing data.

In a possible design, the plurality of pieces of sensing data are of a first category, the compressed data includes quantized compressed data obtained by performing quantization compression on third-dimensional data of the plurality of pieces of sensing data, and third-dimensional data of any piece of sensing data is data in the multi-dimensional data in the sensing data other than the two-dimensional data that corresponds to the position information.

In a possible design, the plurality of pieces of sensing data are of a second category, the compressed data includes geometric structure parameters or geometric structure identification points of at least one geometric structure in which the plurality of pieces of sensing data are located, and the first indication information further indicates a geometric structure in which the plurality of pieces of sensing data are located, and geometric structure parameters or geometric structure identification points of any geometric structure are used to determine the geometric structure.

In a possible design, the compressed data further includes quantized compressed data obtained by performing quantization compression on residuals corresponding to the plurality of pieces of sensing data, the residuals corresponding to the plurality of pieces of sensing data are determined based on the plurality of pieces of sensing data and a plurality of pieces of restored data corresponding to the plurality of pieces of sensing data, and restored data corresponding to any piece of sensing data is determined based on position information corresponding to the sensing data and a geometric structure in which the sensing data is located.

In a possible design, the plurality of pieces of sensing data are of a third category, the first indication information further indicates a bounding box in which the plurality of pieces of sensing data are located, the compressed data includes quantized compressed data obtained by performing quantization compression on bounding box endpoints of the plurality of pieces of sensing data and/or sensing data located at the bounding box endpoints or quantized compressed data obtained by performing quantization compression on third-dimensional data of a plurality of pieces of sensing data located in any bounding box indicated by the first indication information, and third-dimensional data of any piece of sensing data is data in the multi-dimensional data in the sensing data other than the two-dimensional data that corresponds to the position information.

In a possible design, the quantized compressed data obtained by performing quantization compression on the third-dimensional data of the plurality of pieces of sensing data located in any bounding box includes: quantized compressed data obtained by performing quantization compression on third-dimensional data of all the sensing data located in the bounding box; or quantized compressed data obtained by performing quantization compression on the bounding box endpoints of the plurality of pieces of sensing data and/or third-dimensional data of the sensing data located at the bounding box endpoints; or quantized compressed data obtained by performing quantization compression on third-dimensional data of a plurality of pieces of sampled sensing data among the plurality of pieces of sensing data, and a quantity of the plurality of pieces of sampled sensing data is less than a quantity of the plurality of pieces of sensing data.

In a possible design, the method further includes: sending a compression configuration to the first communication apparatus, where the compression configuration indicates one or more categories of sensing data to be transmitted, and the categories of the plurality of pieces of sensing data belong to the categories of the sensing data to be transmitted that are indicated by the compression configuration.

In a possible design, the compression configuration further indicates a compression parameter and/or compression performance respectively corresponding to the one or more categories of sensing data to be transmitted, where the compressed data meets a requirement of the compression parameter and/or the compression performance.

In a possible design, the compression configuration further indicates transmission priorities respectively corresponding to the one or more categories of the sensing data to be transmitted.

In a possible design, the compressed data further includes reconstruction performance of the plurality of pieces of sensing data; and the method further includes: sending second indication information to the first communication apparatus when the reconstruction performance does not meet a reconstruction performance threshold, where the second indication information indicates to send residuals corresponding to the plurality of pieces of sensing data; and receiving the residuals corresponding to the plurality of pieces of sensing data from the first communication apparatus, where the residuals corresponding to the plurality of pieces of sensing data are determined based on the plurality of pieces of sensing data and a plurality of pieces of restored data corresponding to the plurality of pieces of sensing data, and restored data corresponding to any piece of sensing data is determined based on position information corresponding to the sensing data and a geometric structure in which the sensing data is located.

According to a third aspect, an embodiment of this application provides a communication apparatus. The apparatus has a function of implementing the method according to the first aspect or the second aspect. The function may be implemented by hardware, or may be implemented by hardware executing corresponding software. The hardware or software includes one or more modules corresponding to the function, for example, includes an interface unit and a processing unit.

In a possible design, the apparatus may be a device, a chip, or an integrated circuit.

In a possible design, the apparatus includes a memory and a processor. The memory is configured to store instructions executed by the processor. When the instructions are executed by the processor, the apparatus may perform the method according to the first aspect or the second aspect.

According to a fourth aspect, an embodiment of this application provides a communication apparatus. The communication apparatus includes an interface circuit and a processor, and the processor and the interface circuit are coupled to each other. The processor is configured to implement the method according to the first aspect or the second aspect by using a logic circuit or executing instructions. The interface circuit is configured to: receive a signal from a communication apparatus other than the communication apparatus and transmit the signal to the processor, or send a signal from the processor to a communication apparatus other than the communication apparatus. It may be understood that, the interface circuit may be a transceiver, a transceiver machine, a transceiver apparatus, or an input/output interface.

Optionally, the communication apparatus may further include a memory, configured to: store instructions executed by the processor or store input data required for running the instructions by the processor or store data generated after the processor runs instructions. The memory may be a physically independent unit, or may be coupled to the processor, or the processor includes the memory (that is, the processor and the memory are integrated).

In a possible implementation, the communication apparatus may be a device or a chip.

According to a fifth aspect, an embodiment of this application provides a communication system. The communication system includes a first communication apparatus and a second communication apparatus, the first communication apparatus is configured to implement the method in the first aspect, and the second communication apparatus is configured to implement the method in the second aspect.

According to a sixth aspect, an embodiment of this application provides a computer-readable storage medium. The computer-readable storage medium stores a computer program or instructions. When the computer program or the instructions are executed by a processor, the method according to the first aspect or the second aspect may be implemented.

According to a seventh aspect, an embodiment of this application further provides a computer program product, including a computer program or instructions. When the computer program or the instructions are executed by a processor, the method according to the first aspect or the second aspect may be implemented.

According to an eighth aspect, an embodiment of this application further provides a chip system. The chip system includes a processor. The processor is configured to be coupled to a memory. The memory is configured to store a program or instructions. When the program or the instructions are executed by the processor, the method according to the first aspect or the second aspect may be implemented.

For technical effects that can be achieved in the second aspect to the eighth aspect, refer to the technical effects that can be achieved in the first aspect. Details are not described herein again.

### BRIEF DESCRIPTION OF DRAWINGS

FIG. 1 is a diagram of an architecture of a communication system according to an embodiment of this application;
FIG. 2 is a diagram of an application scenario according to an embodiment of this application;
FIG. 3 is a diagram 1 of a sensing data transmission method according to an embodiment of this application;
FIG. 4 is a diagram of three-dimensional coordinates according to an embodiment of this application;
FIG. 5 is a 2D mapping diagram according to an embodiment of this application;
FIG. 6 is a diagram 1 of a 2D mapping diagram indicating a category of sensing data according to an embodiment of this application;
FIG. 7A is a diagram of a distribution probability of a value of x of sensing data according to an embodiment of this application;
FIG. 7B is a diagram of a distribution probability of a value of y of sensing data according to an embodiment of this application;
FIG. 8 is a diagram of determining a residual according to an embodiment of this application;
FIG. 9 is a diagram 2 of a 2D mapping diagram indicating a category of sensing data according to an embodiment of this application;
FIG. 10 is a diagram of sensing data distribution according to an embodiment of this application;
FIG. 11 is a diagram of sampling and restoration through interpolation of sensing data according to an embodiment of this application;
FIG. 12 is a diagram 3 of a 2D mapping diagram indicating a category of sensing data according to an embodiment of this application;
FIG. 13 is a diagram 2 of a sensing data transmission method according to an embodiment of this application;
FIG. 14 is a diagram of layering according to an embodiment of this application;
FIG. 15 is a diagram of incremental transmission according to an embodiment of this application;
FIG. 16 is a diagram 3 of a sensing data transmission method according to an embodiment of this application;
FIG. 17 is a diagram 1 of a simulation result of sensing data transmission according to an embodiment of this application;
FIG. 18 is a diagram 2 of a simulation result of sensing data transmission according to an embodiment of this application;
FIG. 19 is a diagram 1 of a structure of a communication apparatus according to an embodiment of this application; and
FIG. 20 is a diagram 2 of a structure of a communication apparatus according to an embodiment of this application.

### DESCRIPTION OF EMBODIMENTS

The technical solutions in embodiments of this application may be applied to various communication systems, for example, a long term evolution (long term evolution, LTE) system, an evolved LTE (LTE-advanced, LTE-A) system, a universal mobile telecommunications system (universal mobile telecommunications system, UMTS), a 5th generation (5th generation, 5G) mobile communication system, a 5th generation (5th generation, B5G) mobile communication system, a beyond 5th generation (beyond 5G, B5G) mobile communication system, or a post-5G evolved communication system (for example, a 6G mobile communication system). The communication system may alternatively be a device to device (device-to-device, D2D) network, a Wi-Fi network, a machine to machine (machine to machine, M2M) network, an internet of things (internet of things, IoT) network, or another network.

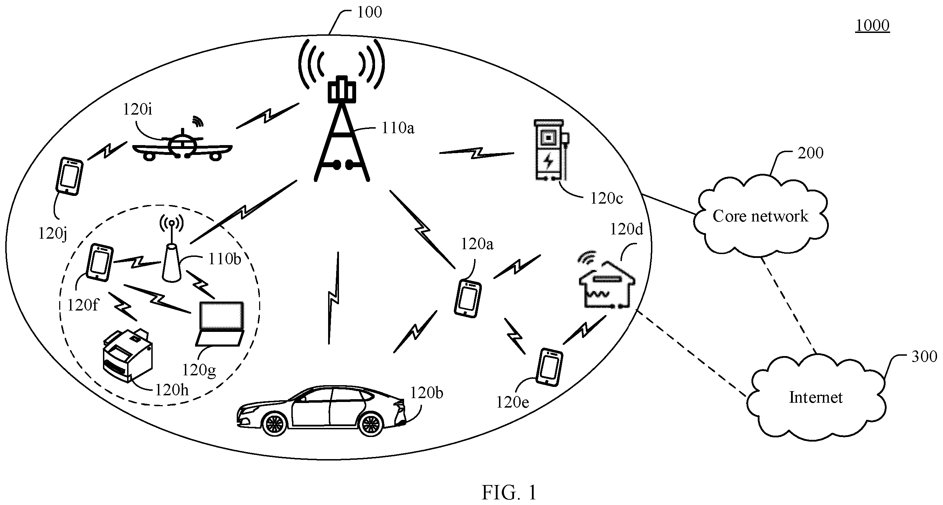

An architecture of a communication system to which embodiments of this application may be applied may be shown in FIG. 1. A communication system 1000 includes a radio access network (radio access network, RAN) 100 and a core network (core network, CN) 200. Optionally, the communication system 1000 may further include an internet 300. The RAN 100 includes at least one network device (for example, 110a and 110b in FIG. 1, which are collectively referred to as 110) and at least one terminal device (for example, 120a to 120j in FIG. 1, which are collectively referred to as 120). The RAN 100 may further include another RAN node, for example, a wireless relay device and/or a wireless backhaul device (not shown in FIG. 1). The terminal device 120 is connected to the network device 110 in a wireless manner. The network device 110 is connected to the core network 200 in a wireless or wired manner. A core network device in the core network 200 and the network device 110 in the RAN 100 may respectively be different physical devices, or may be a same physical device that integrates a logical function of the core network and a logical function of the radio access network.

The RAN 100 may be a cellular system related to the 3rd generation partnership project (3rd generation partnership project, 3GPP), for example, a 4G system, a 5G system, or a system evolved after 5G (for example, a 6G mobile communication system). The RAN 100 may alternatively be an open access network (open RAN, O-RAN or ORAN), a cloud radio access network (cloud radio access network, CRAN), or a Wi-Fi system. The RAN 100 may alternatively be a communication system that integrates two or more of the foregoing systems.

An apparatus provided in embodiments of this application may be used in the network device 110 or the terminal device 120. It may be understood that FIG. 1 shows only a possible architecture of the communication system to which embodiments of this application may be applied. In another possible scenario, the architecture of the communication system may alternatively include another device.

The network device 110 is a node in a radio access network (radio access network, RAN), and may also be referred to as an access network device or a RAN node (or device). The network device 110 is configured to help the terminal device implement wireless access. A plurality of network devices 110 in the communication system 1000 may be nodes of a same type, or may be nodes of different types. In some scenarios, roles of the network device 110 and the terminal device 120 are relative. For example, the network element 120i in FIG. 1 may be a helicopter or an uncrewed aerial vehicle, and may be configured as a mobile base station. For the terminal device 120j that accesses the RAN 100 through the network element 120i, the network element 120i is a base station. However, for the base station 110a, the network element 120i is a terminal device. The network device 110 and the terminal device 120 are sometimes referred to as communication apparatuses. For example, network elements 110a and 110b in FIG. 1 may be understood as communication apparatuses having a base station function, and the network elements 120a to 120j may be understood as communication apparatuses having a terminal device function.

In a possible scenario, the network device may be a base station (base station), an evolved NodeB (evolved NodeB, eNodeB), a transmission reception point (transmission reception point, TRP), a transmitting point (transmitting point, TP), a next generation NodeB (next generation NodeB, gNB), a base station in a future mobile communication system, a satellite, an access point (access point, AP) in a Wi-Fi system, an integrated access and backhaul (integrated access and backhaul, IAB) node, a network device that is in a non-terrestrial network (non-terrestrial network, NTN) communication system of a mobile switching center and that may be deployed on a highaltitude platform or a satellite, or the like. The network device may be a macro base station (for example, 110a in FIG. 1), a micro base station or an indoor base station (for example, 110b in FIG. 1), a relay node or a donor node, or a radio controller in a CRAN scenario. The network device may alternatively be a device with a base station function in device to device (device to device, D2D) communication, internet of vehicles communication, uncrewed aerial vehicle communication, or machine communication. Optionally, the network device may alternatively be a server, a wearable device, a vehicle, a vehicle-mounted device, or the like. For example, an access network device in a vehicle to everything (vehicle to everything, V2X) technology may be a road side unit (road side unit, RSU).

In another possible scenario, a plurality of network devices collaborate to assist a terminal device in implementing wireless access, and different network devices separately implement a part of functions of a base station. For example, the network device may be a central unit (central unit, CU), a distributed unit (distributed unit, DU), a CU-control plane (control plane, CP), a CU-user plane (user plane, UP), a radio unit (radio unit, RU), or the like. The CU and the DU may be separately arranged, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH). It may be understood that the network device may be a CU node, a DU node, or a device including a CU node and a DU node. In addition, the CU may be classified as a network device in an access network RAN, or the CU may be classified as a network device in a core network CN. This is not limited herein.

In different systems, the CU (or the CU-CP and the CU-UP), the DU, or the RU may also have different names, but a person skilled in the art may understand meanings thereof. For example, in an ORAN system, the CU may also be referred to as an O-CU (open CU), the DU may also be referred to as an O-DU, the CU-CP may also be referred to as an O-CU-CP, the CU-UP may also be referred to as an O-CU-UP, and the RU may also be referred to as an O-RU. For ease of description, the CU, the CU-CP, the CU-UP, the DU, and the RU are used as examples for description in this application. Any one of the CU (or the CU-CP or the CU-UP), the DU, and the RU in this application may be implemented by using a software module, a hardware module, or a combination of a software module and a hardware module.

A form of the network device is not limited in embodiments of this application. An apparatus configured to implement a function of the network device may be the network device, or may be an apparatus that can support the network device in implementing the function, for example, a chip system. The apparatus may be mounted in the network device or used in matching with the network device.

The terminal device 120 may also be referred to as a terminal, user equipment (user equipment, UE), a mobile station (mobile station, MS), a mobile terminal (mobile terminal, MT), or the like, and may be a device configured to provide voice or data connectivity for a user, or may be an internet of things device, or may be a station (station, STA) in a Wi-Fi system. For example, the terminal device includes a hand-held device, a vehicle-mounted device, or the like that has a wireless connection function. Currently, the terminal device may be a mobile phone, a tablet computer, a notebook computer, a palmtop computer, a mobile internet device (mobile internet device, MID), a wearable device (for example, a smartwatch, a smart band, a pedometer, or smart glasses), a vehicle-mounted device (for example, a car, a bicycle, an electric vehicle, an airplane, a ship, a train, or a high-speed train), a satellite terminal, a virtual reality (virtual reality, VR) device, an augmented reality (augmented reality, AR) device, a smart point of sale (point of sale, POS) machine, a customer premises equipment (customer premises equipment, CPE), a wireless terminal in industrial control, a smart home device (for example, a refrigerator, a television, an air conditioner, or an electric meter), a smart robot, a robot arm, a workshop device, a wireless terminal in unmanned driving, a wireless terminal in telemedicine, a wireless terminal in a smart grid (smart grid), a wireless terminal in transportation safety, a wireless terminal in a smart city, a wireless terminal in a smart home, a flight device (for example, a smart robot, a hot air balloon, an uncrewed aerial vehicle, or an airplane), or the like. The terminal device may alternatively be another device having a terminal function. For example, the terminal device may alternatively be a device that functions as a terminal in D2D communication.

A device form of the terminal device is not limited in embodiments of this application. An apparatus configured to implement a function of the terminal device may be a terminal device, or may be an apparatus that can support the terminal device in implementing the function for example, a chip system. The apparatus may be mounted in a terminal device or used in matching with a terminal device. In this embodiment of this application, the chip system may include a chip, or may include a chip and another discrete component.

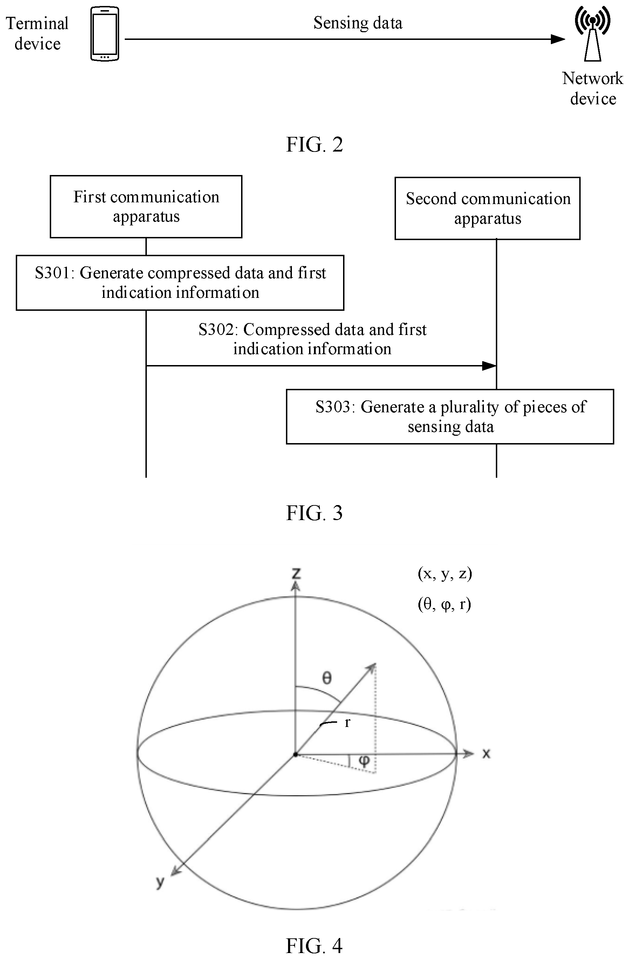

Based on the architecture of the communication system shown in FIG. 1, FIG. 2 shows an example of an application scenario to which an embodiment of this application is applicable. The application scenario includes a terminal device and a network device. The terminal device (for example, a mobile phone, a computer, a car, or an airplane) may scan a surrounding environment by using a sensor disposed on the terminal device, to obtain sensing data (which may also be referred to as point cloud data or imaging data), and send compressed sensing data to the network device. The network device may perform information fusion and environment map construction based on the sensing data reported by the terminal device.

In addition, it should be understood that the sensing data in embodiments of this application may be data obtained by a communication apparatus (for example, a terminal device or a vehicle-mounted device) by scanning a surrounding environment by using a sensor (for example, one or more of a visual sensor, an electromagnetic wave sensor (or an antenna), or a millimeter-wave sensor). For example, each piece of sensing data may correspond to one point in space, and may include at least one-dimensional data obtained by scanning the point, for example, one or more of three-dimensional coordinates (each-dimension coordinate may correspond to one-dimensional data), echo signal strength, and round-trip time of a sensing signal (for example, an electromagnetic wave signal) of the point. Each piece of data may be one-dimensional data included in the sensing data. Restored data may be sensing data obtained through restoration based on a part of information (or data). For example, the sensing data obtained through restoration is decompressed based on compressed data obtained by compressing the sensing data. A residual corresponding to the sensing data may be a difference between the sensing data and restored data of the sensing data.

Ordinal numbers such as "first" and "second" mentioned in embodiments of this application are used to distinguish between a plurality of objects, but are not used to limit sizes, content, a sequence, a time sequence, priorities, importance, or the like of the plurality of objects. For example, a first communication apparatus and a second communication apparatus do not mean different priorities, importance degrees, or the like corresponding to two messages.

In embodiments of this application, unless otherwise specified, a quantity of nouns represents "a singular noun or a plural noun", that is, "one or more". "At least one" means one or more, and "a plurality of" means two or more. "And/or" describes an association relationship between associated objects and indicates that three relationships may exist. For example, A and/or B may indicate the following three cases: Only A exists, both A and B exist, and only B exists, where A and B may be singular or plural. The character "/" generally indicates an "or" relationship between the associated objects. For example, A/B indicates A or B. "At least one of the following items (pieces)" or a similar expression thereof means any combination of these items, including a single item (piece) or any combination of a plurality of items (pieces). For example, at least one item (piece) of a, b, or c indicates: a, b, c, a and b, a and c, b and c, or a, b, and c. Herein, a, b, and c may be singular or plural.

This application provides a sensing data transmission method and an apparatus. It is considered that importance and features of different categories of sensing data in sensing data may be different. In this case, the different categories of sensing data may be compressed in different compression schemes, to improve compression flexibility for sensing data and achieve higher compression efficiency. The following describes in detail embodiments of this application with reference to accompanying drawings.

The sensing data transmission method provided in embodiments of this application may be performed by a first communication apparatus and a second communication apparatus. The first communication apparatus and the second communication apparatus are different communication apparatuses. The first communication apparatus (or the second communication apparatus) may be a terminal device, a component (for example, a processor, a chip, or a chip system) of a terminal device, or an apparatus that matches a terminal device; or may be a network device, a component (for example, a processor, a chip, or a chip system) of a network device, or an apparatus that matches a network device. The first communication apparatus may be used as a transmit end of the sensing data to compress the sensing data, and the second communication apparatus may be used as a receive end to restore the sensing data through decompression.

FIG. 3 is a diagram 1 of a sensing data transmission method according to an embodiment of this application. The method includes the following steps.

S301: A first communication apparatus generates compressed data and first indication information, where the first indication information indicates categories of a plurality of pieces of sensing data, and the compressed data is obtained by compressing the plurality of pieces of sensing data according to compression schemes respectively corresponding to the categories of the plurality of pieces of sensing data.

Sensing data of a same category among the plurality of pieces of sensing data corresponds to a same compression scheme in a correspondence between different categories of sensing data and different compression schemes.

S302: The first communication apparatus sends the compressed data and the first indication information to a second communication apparatus, and correspondingly, the second communication apparatus receives the compressed data and the first indication information.

In this embodiment of this application, the first communication apparatus may be used as a sensing device or a scanning device to scan an area, so as to obtain sensing data; or the first communication apparatus may obtain sensing data from another communication apparatus. This is not limited in this application. For example, each piece of sensing data may correspond to one point in space, and the sensing data may include at least one-dimensional data obtained by scanning the point, for example, one or more of three-dimensional coordinates (each-dimension coordinate may correspond to one-dimensional data), echo signal strength, and round-trip time of a sensing signal (for example, an electromagnetic wave signal) of the point.

Refer to a diagram of three-dimensional coordinates shown in FIG. 4. Three-dimensional coordinates included (or recorded) in the sensing data may be spherical coordinates (θ, φ, R) in a spherical coordinate system, represented by a vertical angle θ (also referred to as a pitch angle), a horizontal angle φ (also referred to as a yaw angle), and a distance R from a point to an origin; or Cartesian coordinates (x, y, z) in a Cartesian coordinate system, represented by a value of x (an abscissa), a value of y (an ordinate), and a value of z (a vertical coordinate); or alternatively, three-dimensional coordinates in another three-dimensional coordinate system (for example, a cylindrical coordinate system). A specific form of the three-dimensional coordinates is not limited in this application. It may be understood that three-dimensional coordinates in different coordinate systems may be converted to each other.

For example, an algorithm of mapping from the Cartesian coordinate system to the spherical coordinate system may satisfy the following formula: $θ = arcsin \left(z/\sqrt{{x}^{2} + {y}^{2} + {z}^{2}}\right) , φ = arccos \left(x/\sqrt{{x}^{2} + {y}^{2}}\right) , and R = \sqrt{{x}^{2} + {y}^{2} + {z}^{2}} .$

In this embodiment of this application, considering that different sensing data includes (or records) different features, a plurality of pieces of sensing data obtained may be classified based on a feature (for example, a value range) of one-dimensional data or multi-dimensional data, and different categories of sensing data may be compressed using different compression schemes.

For example, the sensing data includes the round-trip time of a sensing signal. When the first communication apparatus scans an area, the longer distance between a target object in the area and the first communication apparatus corresponds to longer round-trip time of a sensing signal in the sensing data obtained by scanning the object. Therefore, in a possible implementation, the sensing data may be classified based on the round-trip time of the sensing signal. For example, sensing data whose round-trip time of a sensing signal is within a round-trip time range 1 may be classified into a category 1, sensing data whose round-trip time of a sensing signal is within a round-trip time range 2 may be classified into a category 2, and sensing data whose round-trip time of a sensing signal is within a round-trip time range 3 may be classified into a category 3.

For example, the sensing data includes three-dimensional coordinates. When the first communication apparatus scans an area, a plurality of pieces of sensing data obtained by scanning an object in the area have three-dimensional coordinates that correspond to points on the surface of that object. Therefore, in a possible implementation, the sensing data may also be classified based on categories of target objects corresponding to the sensing data.

In an example, an artificial intelligence (artificial intelligence, AI) model used to identify a category (for example, a ground, a building, a vehicle, vegetation, or a utility pole) of a target object corresponding to sensing data may be trained. The first communication apparatus may input a plurality of pieces of obtained sensing data into the AI model for processing, to obtain a category of a target object corresponding to each piece of sensing data, and use the category as a category of the corresponding sensing data.

In this embodiment of this application, different categories of sensing data correspond to different compression schemes. For example, a category 1 corresponds to a compression scheme 1, and a category 2 corresponds to a compression scheme 2. Different compression schemes may mean different compression schemes, or may indicate different compression parameters (or compression degrees). For example, a Kd tree (KDtree) compression scheme and a compression scheme for performing quantization compression on the sensing data with sampling (unsampled sensing data is restored through interpolation) may be different compression schemes; and a compression scheme for performing quantization compression on the sensing data with sampling with a sampling rate of 1/2 and a compression scheme for performing quantization compression on the sensing data with sampling with a sampling rate of 1/4 may also be different compression schemes.

The correspondence between the different categories of the sensing data and the different compression schemes may be preconfigured in the first communication apparatus, or may be indicated by another communication apparatus (for example, the second communication apparatus) to the first communication apparatus. A manner in which the first communication apparatus obtains (or determines) the correspondence between the different categories of the sensing data and the different compression schemes is not limited in this application.

It may be understood that, if data features of different categories of sensing data are the same or similar, for example, three-dimensional coordinates included in the sensing data all conform to distribution of three-dimensional coordinates of points on a plane, the different categories of the sensing data may also correspond to a same compression scheme.

After the first communication apparatus obtains the plurality of pieces of sensing data (a set of sensing data), for each category of sensing data, the first communication apparatus may compress the obtained sensing data of the category in a compression scheme corresponding to the category, to generate compressed data. After generating the compressed data, the first communication apparatus may send, to the second communication apparatus, the compressed data and first indication information that may indicate categories of the plurality of pieces of obtained sensing data.

For example, the first communication apparatus obtains 35 pieces of sensing data by scanning an area, where categories of 20 pieces of sensing data are a category 1, and categories of 15 pieces of sensing data are a category 2. The first communication apparatus may compress the 20 pieces of sensing data of the category 1 in a compression scheme 1 corresponding to the category 1 (for example, a compression scheme for compressing all sensing data), to generate compressed data of the 20 pieces of sensing data corresponding to the category 1; and compress the 10 pieces of sensing data of the category 2 in a compression scheme 2 corresponding to the category 2 (for example, a compression scheme for compressing the sensing data with a sampling rate of 1/2 and restoring other unsampled sensing data through interpolation), to generate compressed data of the 10 pieces of sensing data corresponding to the category 2. After generating the compressed data, the first communication apparatus may send, to the second communication apparatus, the compressed data of the 20 pieces of sensing data corresponding to the category 1, the compressed data of the 10 pieces of sensing data corresponding to the category 2, and first indication information indicating categories of the 35 pieces of obtained sensing data.

In a possible implementation, the first indication information may indicate the categories of the plurality of pieces of sensing data by using a sequence, a bitmap, or the like. In an example, a sequence is 1, 1, 2, 3, ..., 4, where 1, 2, 3, and 4 are respectively indexes of a category 1, a category 2, a category 3, and a category 4. The sequence may indicate that a category of 1^{st} piece of sensing data is the category 1, a category of 2^{nd} piece of sensing data is the category 1, a category of 3^{rd} piece of sensing data is the category 2, a category of 4^{th} piece of sensing data is the category 3, ..., and a category of last piece of sensing data is the category 4.

Certainly, the first indication information may alternatively indicate the category of the sensing data in a manner, for example, a two-dimensional (two-dimensional, 2D) mapping diagram. For example, the sensing data includes three-dimensional data (for example, three-dimensional coordinates). For the plurality of pieces of obtained sensing data, the first communication apparatus may determine position information (for example, a 2D structure location) based on two-dimensional data (for example, two-dimensional coordinates) of any piece of sensing data, and use an index (or an identifier) of a category corresponding to the sensing data as a fill value of the position information, to design a 2D mapping diagram.

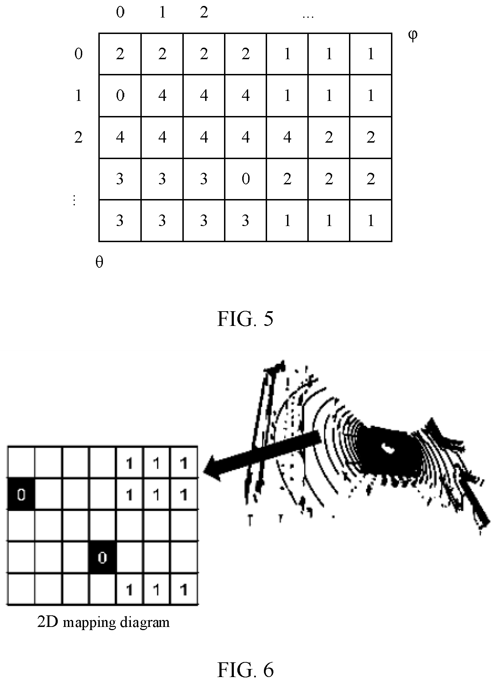

For example, the first communication apparatus may quantize (θ, φ) in three-dimensional coordinates (θ, φ, r) of any piece of sensing data, then determine a 2D structure location of the sensing data, and fill the 2D structure location of the sensing data with an index (or an identifier) of a category corresponding to the sensing data, to obtain a 2D mapping diagram shown in FIG. 5. Each block in the 2D mapping diagram corresponds to one 2D structure location and represents one piece of sensing data. A horizontal axis represents a quantized value of the horizontal angle φ, a vertical axis represents a quantized value of the vertical angle θ, and a value filled in each block represents an index (or an identifier) of a category corresponding to sensing data represented by the block. If a fill value is 1, it represents that sensing data represented by the block corresponds to a category whose index is 1 (for example, a category 1). If a fill value is 2, it represents that sensing data represented by the block corresponds to a category whose index is 2 (for example, a category 2). If a fill value is 3, it represents that sensing data represented by the block corresponds to a category whose index is 3 (for example, a category 3). If a fill value is 4, it represents that sensing data represented by the block corresponds to a category whose index is 4 (for example, a category 4). If a fill value is 0, it may represent that there is no sensing data in the block (that is, a 2D structure location), or no corresponding information in a 2D structure location corresponding to the block (that is, a 2D structure location) is a hole point.

In some implementations, the first indication information may further indicate position information (for example, a 2D structure location) of the plurality of pieces of sensing data, and the position information may indicate (or determine) two-dimensional data of the plurality of pieces of sensing data. For example, the first indication information may indicate categories of the plurality of pieces of sensing data in a manner of the 2D mapping diagram shown in FIG. 5, and indicate a 2D structure location of each piece of sensing data. The 2D structure location may indicate (or determine) (θ, φ) in three-dimensional coordinates (θ, φ, r) of the sensing data.

In an implementation, when the sensing data includes three-dimensional data (for example, three-dimensional coordinates), a compression scheme based on a 2D indication+a fill value may be considered.

For example, the three-dimensional coordinates of the plurality of pieces of sensing data are three-dimensional coordinates (θ, φ, R) in a spherical coordinate system. A 2D structure location of each piece of sensing data may be determined based on a value of θ and a value of φ of each piece of sensing data, and the 2D structure location of each piece of sensing data is indicated by the first indication information (for example, the 2D mapping diagram). Quantization compression may be performed on an R-value sequence formed by values of R of the plurality of pieces of sensing data to obtain quantized compressed data. The quantized compressed data may be data obtained by compressing a quantized R-value sequence.

A quantization range corresponding to quantization may be preconfigured or determined (for example, determined by the first communication apparatus and the second communication apparatus through negotiation before data compression, or pre-defined in a protocol or the like and stored in the first communication apparatus and the second communication apparatus), or may be determined by the first communication apparatus. For example, a range of values of R in an R-value sequence that needs to be quantized is [Rₘᵢₙ, Rₘₐₓ], and the first communication apparatus may determine that the quantization range is [Rₘᵢₙ, Rₘₐₓ]. It may be understood that, if the quantization range used when the sensing data is compressed is determined by the first communication apparatus, the compressed data sent by the first communication apparatus to the second communication apparatus may not only include the quantized compressed data obtained by performing quantization compression on the sensing data, but also include the quantization range. During quantization, a smaller quantization range indicates a larger quantity of quantization bits and higher quantization precision.

To further improve compression efficiency, when the sensing data includes three-dimensional data (for example, three-dimensional coordinates), a compression scheme based on a 2D indication+fill value selection may be considered.

In an example, the spherical coordinates may be transformed into (θ, φ, a), where a ∈ one or more of {x, y, z, r, R...}. θ represents a vertical angle in a spherical coordinate system, θ represents a horizontal angle in the spherical coordinate system, x represents an abscissa in a Cartesian coordinate system, y represents an ordinate in the Cartesian coordinate system, z represents a vertical coordinate in the Cartesian coordinate system, r represents a projected distance on a horizontal plane (xOy plane) in the Cartesian coordinate system, and R represents a distance to an origin in the spherical coordinate system, where $r = \sqrt{{x}^{2} + {y}^{2}}$. x, y, z, r, R, and the like may be determined based on the three-dimensional coordinates included (or recorded) in the sensing data. Details are not described again. It may be understood that a may alternatively be a projected distance on the xOz plane in the Cartesian coordinate system, a projected distance on a yOz plane in the Cartesian coordinate system, or the like.

A value of a may be selected based on an information entropy or a value range of one or more of an x-value sequence, a y-value sequence, a z-value sequence, an r-value sequence, an R-value sequence, and the like corresponding to the plurality of pieces of sensing data.

In an example, after values in the x-value sequence, the y-value sequence, the z-value sequence, the r-value sequence, and the R-value sequence corresponding to the plurality of pieces of sensing data are quantized by using same quantization performance (for example, a same quantity of quantization levels), an information entropy H(a) corresponding to each sequence is calculated, and a value (for example, x, y, z, r, R...) corresponding to a sequence with a smallest H(a) is selected as a. H(x) may be calculated according to the following formula:

H(a)=-∑P(ai)log(2,P(ai)), (i=1, 2, ..., n), where a may be one or more of x, y, z, r, R, and the like, n is an amount of sensing data, i is an index of a value in a sequence, and ai is a symbol in quantization space (for example, a quantized value of an i^{th} a in the sequence).

In an example, a value (for example, x, y, z, r, R...) corresponding to a sequence with a smallest g may be selected as a based on ranges g of values in the x-value sequence, the y-value sequence, the z-value sequence, the r-value sequence, and the R-value sequence corresponding to the plurality of pieces of sensing data. A range g of a value in any sequence may be determined based on a difference between a maximum value max and a minimum value min in the sequence.

In some implementations, when a plurality of pieces of sensing data of the ground (for example, a first category: a category 1) are compressed by using a compression scheme based on fill value selection, because fluctuation of values of z of the plurality of pieces of sensing data of the ground category is the smallest, and a value range of a z-value sequence is the smallest, three-dimensional data (for example, three-dimensional coordinates) of each piece of sensing data may be transformed into (θ, φ, z), and quantization compression is performed on the z-value sequence of the plurality of sensing data, to obtain a quantization compression range and quantization compression data S₁.

For the plurality of pieces of sensing data of the ground, compressed data corresponding to the ground sent by the first communication apparatus to the second communication apparatus may include a quantization range (optionally, for example, may be included when the first communication apparatus determines a quantization range based on a value range of a sequence that needs to be quantized, and the like), a quantization step (for example, a quantity of quantization bits, and optionally may be included when the first communication apparatus independently determines the quantization step and the second communication apparatus has not learned the quantization step), and the quantized compressed data, and may further include an index (for example, an index of z) used for selecting the value of a. Certainly, the selection of the value of a may also be directly associated with the category. For example, when the category is the ground, z is selected as the value of a.

Refer to FIG. 6. After receiving the first indication information (2D mapping diagram) and the compressed data from the first communication apparatus, the second communication apparatus may determine, based on a fill value 1, a plurality of pieces of sensing data of the ground category, obtain (θ, φ) of each piece of sensing data based on the first indication information (2D mapping diagram), and dequantize quantized compressed data based on a quantization range and a quantization step, to obtain z of each piece of sensing data and to restore three-dimensional coordinates of each sensing point.

Structures such as buildings typically exhibit geometric structures (for example, planes or curved surfaces). The three-dimensional coordinate distribution of a plurality of pieces of sensing data obtained by scanning such structures usually matches that of points on the geometric structure. Therefore, for sensing data including three-dimensional coordinates, for a plurality of pieces of sensing data of the building (for example, a second category: a category 2), a compression scheme based on a 2D indication combined with geometric structure (for example, plane, curved surface, polygon, polyhedron, cube, cylinder, or cone) fitting may be used.

For example, if the geometric structure is a plane, the first communication apparatus may extract fitting sensing data based on the distribution probability of one or more of values of x (or values of y or values of z) among the plurality of pieces of sensing data of the building and a segment of consecutive values of x (or values of y or values of z) with a large occurrence probability, and obtain at least one plane through fitting, to obtain plane parameters or plane identification points of the at least one plane. Any plane F may be represented by using the formula F=Ax+By+Cz+D=0, with parameters (A, B, C, D). The plane identification points are points that can be used to determine the plane, for example, three non-collinear points on the plane, which may be uniquely determined by using three-dimensional coordinates of the three points.

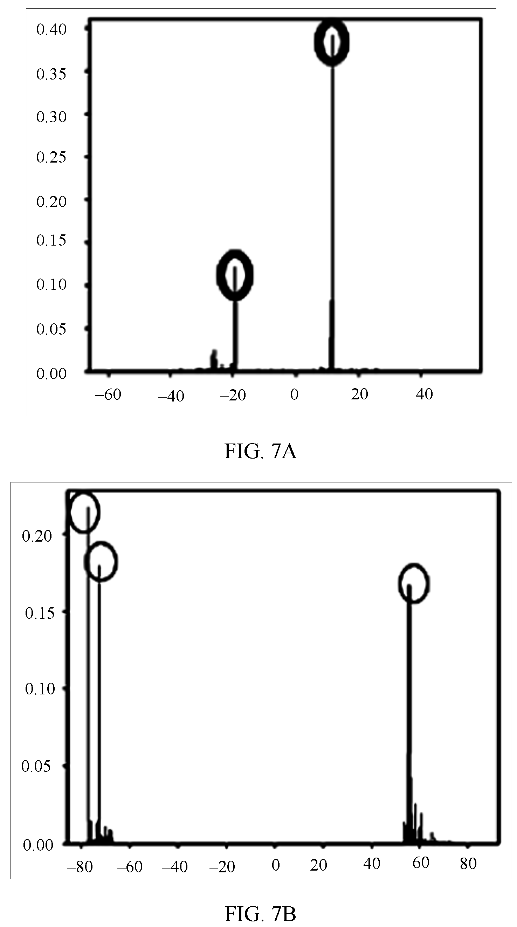

Referring to FIG. 7A, which shows distribution probabilities of the values of x of the plurality of pieces of sensing data, the horizontal axis represents the values of x (an abscissa), and the vertical axis represents distribution probabilities (or proportions). As shown in FIG. 7A, the values of x with distribution probabilities of the sensing data exceeding a distribution probability threshold (for example, 0.05) are -19 and 12. It may be determined that distribution ranges of the values of x [-19.25, -18.75] and [11.75, 12.25] respectively corresponding to -19 and 12 may be used for plane fitting. The first communication apparatus may obtain a sensing plane F₁ through fitting based on a plurality of pieces of sensing data whose values of x are in [-19.25, -18.75] by using a least square method, and obtain a sensing plane F₂ through fitting based on a plurality of pieces of sensing data whose values of x are in [11.75, 12.25] by using a least square method.

Referring to FIG. 7B, which shows distribution probabilities of the values of y of the plurality of pieces of sensing data, the horizontal axis represents the values of y (an ordinate), and the vertical axis represents distribution probabilities (or proportions). As shown in FIG. 7B, the values of y with distribution probabilities of the sensing data exceeding a distribution probability threshold (for example, 0.05) are -77, -75, and 47. It may be determined that distribution ranges of the values of y [-77.25, -76.75], [-75.25, -74.75], and [46.75, 47.25] respectively corresponding to -77, -75, and 47 may be used for plane fitting. The first communication apparatus may obtain a sensing plane F₃ through fitting based on a plurality of pieces of sensing data whose values of y are in [-77.25, -76.75] by using a least square method, obtain a sensing plane F₄ through fitting based on a plurality of pieces of sensing data whose values of y are in [-75.25, -74.75] by using a least square method, and obtain a sensing plane F₅ through fitting based on a plurality of pieces of perception data whose values of y are located in [46.75, 47.25] by using a least square method.

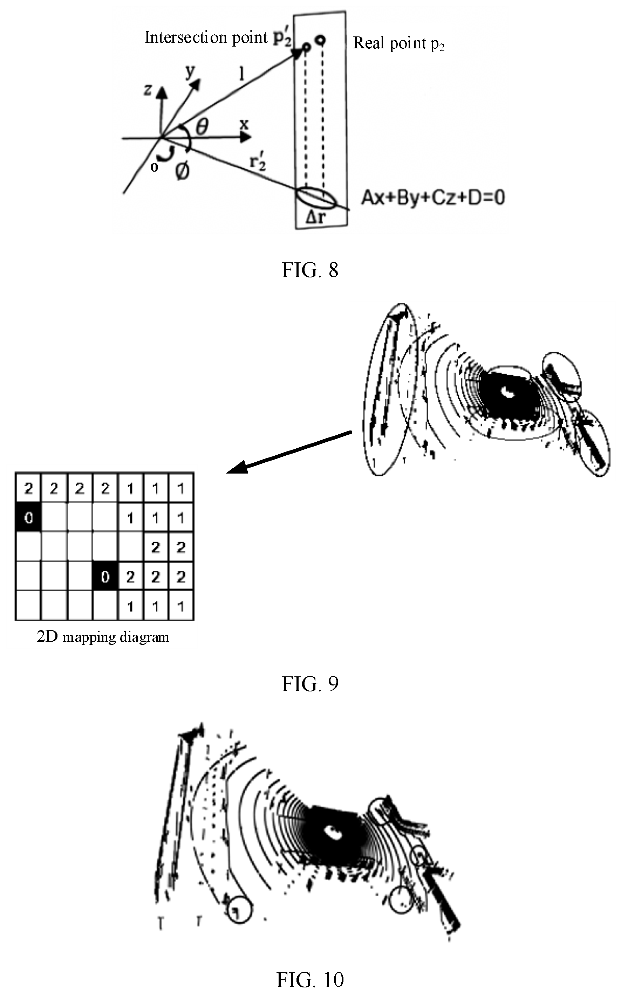

For example, the 2D mapping diagram uses the horizontal axis for quantized values of a horizontal angle φand the vertical axis for quantized values of a vertical angle θ. Refer to FIG. 8. Each piece of sensing data corresponds to a 2D structure location in the 2D mapping diagram. A vertical angle θ and a horizontal angle φ of the sensing data may be obtained based on the 2D structure location to determine a straight line I starting from the origin: x/m=y/n=z/k=t, where m, n, and k are components, on an x-axis, a y-axis, and a z-axis, of a space vector determined based on the angle θ and the angle φ, and t is a variable. With reference to plane parameters (A, B, C, D) of a plane in which the sensing data is located, it may be determined that an intersection point ${P}_{2}^{′}$ between the straight line I and the plane Ax+By+Cz+D=0 is the restored data (which may also be referred to as a restored point) of the sensing data.

Further, a difference between projected distances ${r}_{2}^{′}$ and r₂ of the restored data ${P}_{2}^{′}$ and the sensing data (that is, a real point) P₂ on a horizontal plane (or a vertical plane or an x-axis, a y-axis, or a z-axis) is calculated, to obtain a residual Δr corresponding to the sensing data.

In a possible implementation, as shown in FIG. 9, for the plurality of pieces of sensing data of the building, the first communication apparatus may send, to the second communication apparatus, first indication information (for example, a 2D mapping diagram) and compressed data that includes plane parameters of at least one plane in which the plurality of pieces of sensing data are located. Categories of the corresponding plurality of pieces of sensing data may be indicated as the building by using a plurality of 2D structure location indications with fill values of 2 in the 2D mapping diagram. After receiving the first indication information and the plane parameters of the at least one plane, the second communication apparatus may determine a straight line I in 3D space: x/m=y/n=z/k=t based on an angle θ and an angle φ that correspond to each 2D structure location in the 2D mapping diagram. With reference to the plane: Ax+By+Cz+D=0 in which the sensing data is located, an intersection point ${P}_{2}^{′}$: (x, y, z) between the straight line I and the plane may be calculated as restored data (which may also be referred to as a restored point) of the sensing data.

It may be understood that, if the plurality of pieces of sensing data of the building correspond to a plurality of planes, and sensing data respectively corresponding to the plurality of planes is discontinuous in the 2D mapping diagram, each part of continuous sensing data may correspond to one plane. Certainly, if the sensing data respectively corresponding to the plurality of planes is continuous in the 2D mapping diagram, or the like, planes corresponding to the sensing data may alternatively be indicated in the 2D mapping diagram by different fill values (for example, indexes of filled planes), for example, different planes are indicated by fill values 2 and 5. Alternatively, planes corresponding to the sensing data are indicated by filling a value corresponding to the category+an index of the plane. For example, 2A and 2B indicate that the category corresponding to the sensing data is the category 2, and the planes corresponding to the sensing data are a plane A and a plane B. A specific manner of indicating, by the first indication information (for example, the 2D mapping diagram), the planes in which the plurality of pieces of sensing data are located are not limited in this application.

Further, the first communication apparatus may further perform quantization compression on residuals Δr corresponding to the plurality of pieces of sensing data, that is, perform quantization compression on a residual Δr sequence formed by the residuals Δr corresponding to the plurality of pieces of sensing data, to obtain quantized compressed data S₂, and send, to the second communication apparatus, a quantization compression range of the residual Δr sequence (optionally, for example, may be included when the first communication apparatus determines a quantization range based on a value range of a sequence that needs to be quantized, and the like), a quantization step (for example, a quantity of quantization bits, and optionally may be included when the first communication apparatus independently determines the quantization step and the second communication apparatus has not learned the quantization step), and the quantized compressed data S₂. Optionally, the compressed data may further include an index (for example, indicating a residual determined based on the projected distance on the horizontal plane or the vertical plane or the x-axis, or the y-axis, or the z-axis) used for selecting the residual Δr. Certainly, the selection of the residual Δr may be associated with the category. For example, the category is the ground, and for the residual Δr, a residual is fixedly selected based on a projected distance on the horizontal plane.

After restoring the restored point ${P}_{2}^{′}$ of the sensing data, the second communication apparatus calculates the projected distance ${r}_{2}^{′}$ of ${P}_{2}^{′}$, and +Δr is used to restore a real value. With reference to values of θ and φ, the second communication apparatus may resolve real (x, y, z) of the sensing data.

It may be understood that ${r}_{2}^{′} + Δr$ may also be represented in a form of x+Δr, y+Δr, z+Δr, R+Δr, or the like. For example, for the residual Δr, when a difference between projected distances of the restored point ${P}_{2}^{′}$ and a real location (that is, the real point) P₂ of the sensing data on an x-axis, x+Δr may be represented; when a difference between projected distances of the restored point ${P}_{2}^{′}$ and a real location (that is, the real point) P₂ of the sensing data on a y-axis, y+Δr may be represented; when a difference between projected distances of the restored point ${P}_{2}^{′}$ and a real location (that is, the real point) P₂ of the sensing data on a z-axis, z+Δr may be represented, or the like; and when a difference between distances of the restored point ${P}_{2}^{′}$ and a real location (that is, the real point) P₂ of the sensing data to an origin, R+Δr may be represented, or the like. x, y, z, and R may be respectively a coordinate of the restored point ${P}_{2}^{′}$ on the x-axis (or the projected distance on the x-axis), a coordinate of the restored point ${P}_{2}^{′}$ on the y-axis (or the projected distance on the y-axis), a coordinate of the restored point ${P}_{2}^{′}$ on the z-axis (or the projected distance on the z-axis), and the distance from the restored point ${P}_{2}^{′}$ to the origin.

In a possible implementation, corresponding to a plurality of pieces of sensing data of an object that exists in a form of an independent individual, a compression scheme may be designed based on a bounding box of the object. For example, a vehicle exists in a form of a bounding box of the vehicle. For the vehicle, a compression scheme based on a 2D indication+sampling sensing data (feature points) compression in the bounding box may be considered.

Refer to a diagram of sensing data shown in FIG. 10. Sensing data corresponding to each vehicle, that is, sensing data corresponding to a bounding box of each vehicle, may be obtained by clustering sensing data whose category is the vehicle. Each circle in FIG. 10 may represent clustering of sensing data of one vehicle.

For example, a plurality of pieces of sensing data corresponding to the bounding box may be compressed based on fill value selection. For example, three-dimensional coordinates of the plurality of pieces of sensing data corresponding to the bounding box are transformed into (θ, φ, a). A 2D structure location of each piece of sensing data may be determined based on a value of θ and a value of φ of each piece of sensing data, and the 2D structure location of each piece of sensing data is indicated by the first indication information (for example, the 2D mapping diagram). Quantization compression may be performed on an a-value sequence formed by values of a of the plurality of pieces of sensing data to obtain quantized compressed data, where a ∈ one or more of {x, y, z, r, R...}. For the value of a, refer to the description of the compression scheme based on the 2D indication+fill value selection. Details are not described again.

In the foregoing implementation, quantization compression may be performed on third-dimensional data of all the sensing data located in the bounding box to obtain quantized compressed data.

In some implementations, to further reduce a data amount, when quantization compression is performed on the third-dimensional data (for example, a) of the plurality of pieces of sensing data of the bounding box to obtain the quantized compressed data, quantization compression may be performed on only bounding box endpoints (for example, three-dimensional data of the bounding box endpoints or third-dimensional data of the bounding box endpoints) of the plurality of pieces of sensing data and/or third-dimensional data (for example, a) of the sensing data located at the bounding box endpoints, to obtain a quantization range and quantized compressed data

Alternatively, quantization compression is performed on third-dimensional data (for example, a) of a plurality of pieces of sampled sensing data (that is, feature points) in the plurality of pieces of sensing data to obtain quantized compressed data, where a quantity of the plurality of pieces of sampled sensing data is less than a quantity of the plurality of pieces of sensing data.

For the plurality of pieces of sensing data of the vehicle, compressed data corresponding to the vehicle sent by the first communication apparatus to the second communication apparatus may include a quantization range (optionally, for example, may be included when the first communication apparatus determines a quantization range based on a value range of a sequence that needs to be quantized, and the like), a quantization step (for example, a quantity of quantization bits, and optionally may be included when the first communication apparatus independently determines the quantization step and the second communication apparatus has not learned the quantization step), and the quantized compressed data, and may further include an index (for example, indexes of z and x) used for selecting the value of a. Certainly, the selection of the value of a may be directly associated with the category. For example, when the category is the vehicle, z is selected as the value of a.

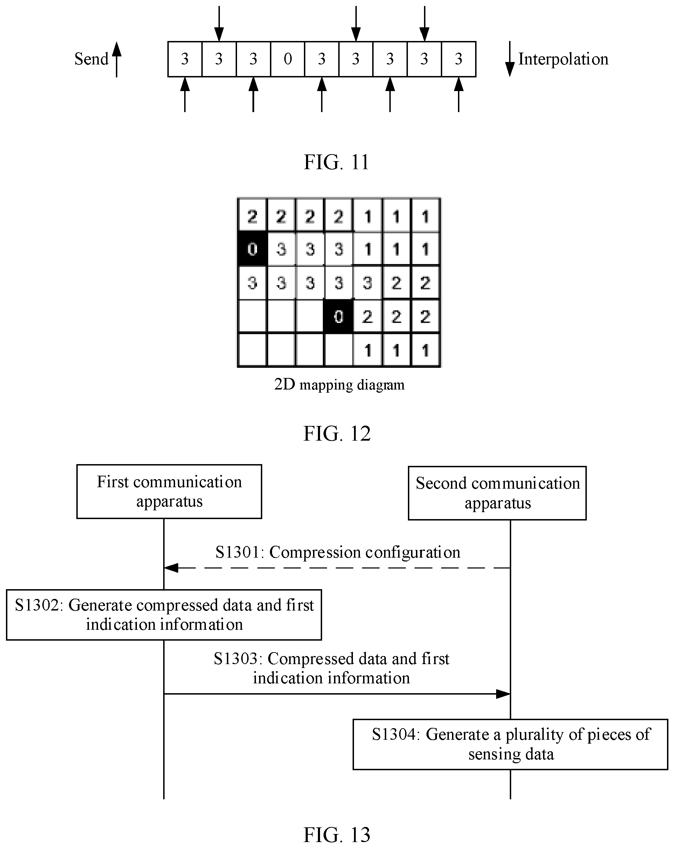

As shown in FIG. 11, when a target shape is fixed and includes many planes/lines, a part of feature data (which may also be referred to as feature points) may be extracted, and an overview is restored based on the feature data. For example, for sensing data at a first segment of consecutive locations, a sequence of a at odd-numbered locations is sent, and a at an even-numbered location is restored through interpolation. For example, aᵢ=(aᵢ-1+aᵢ+1)/2, where i is a location or an index of to-be-restored sensing data.

Refer to FIG. 12. After receiving the first indication information (2D mapping diagram) and the compressed data from the first communication apparatus, the second communication apparatus may determine, based on a fill value 3, a plurality of pieces of sensing data whose category is the vehicle, obtain (θ, φ) of each piece of sensing data based on the first indication information (2D mapping diagram), dequantize quantized compressed data based on a quantization range and a quantization step, and perform restoration through interpolation, to obtain z of each piece of sensing data and to restore three-dimensional data (for example, three-dimensional coordinates) of each piece of sensing data.

It may be understood that, if the plurality of pieces of sensing data of the vehicle correspond to a plurality of bounding boxes, the bounding boxes corresponding to the sensing data may be indicated in the 2D mapping diagram by different fill values (for example, indexes of filled bounding boxes), for example, different bounding boxes are indicated by fill values 3 and 6. Alternatively, the bounding boxes corresponding to the sensing data may be indicated by an index corresponding to the category+an index of the bounding box. For example, 3A and 3B indicate that the category corresponding to the sensing data is the category 3, and planes corresponding to the sensing data are a bounding box A and a bounding box B. A specific manner of indicating, by the first indication information (for example, the 2D mapping diagram), the bounding boxes in which the plurality of pieces of sensing data are located are not limited in this application.

Certainly, the compression scheme designed based on the bounding box may further include performing quantization compression on bounding box endpoints of the plurality of pieces of sensing data and/or sensing data located at the bounding box endpoints to obtain quantized compressed data. The receive end may restore the plurality of pieces of sensing data through interpolation or the like based on the bounding box endpoints and/or the sensing data located at the bounding box endpoints.

S303: The second communication apparatus generates the plurality of pieces of sensing data, where the plurality of pieces of sensing data are obtained by decompressing the compressed data in decompression schemes corresponding to the categories of the plurality of pieces of sensing data.

Sensing data of a same category among the plurality of pieces of sensing data corresponds to a same decompression scheme in a correspondence between different categories of sensing data and different decompression schemes.

In this embodiment of this application, different categories of sensing data correspond to different decompression schemes, and a decompression scheme corresponding to any category of sensing data may be used to decompress compressed data of the category of sensing data. After receiving the compressed data and the first indication information from the first communication apparatus, the first communication apparatus may decompress the compressed data in a corresponding decompression scheme based on the category of the sensing data indicated by the first indication information, to obtain the plurality of pieces of sensing data.

For example, the compressed data includes compressed data of 20 pieces of sensing data that corresponds to a category 1 and that is obtained by compressing the 20 pieces of sensing data corresponding to the category 1 in a compression scheme 1 corresponding to the category 1, and compressed data of 15 pieces of sensing data that corresponds to a category 2 and that is obtained by compressing the 15 pieces of sensing data corresponding to the category 2 in a compression scheme 2 corresponding to the category 2. The second communication apparatus may decompress the compressed data of the 20 pieces of sensing data corresponding to the category 1 in the decompression scheme 1 corresponding to the category 1, to obtain the 20 pieces of sensing data of the category 1; and may decompress the compressed data of the 15 pieces of sensing data corresponding to the category 2 in the decompression scheme 2 corresponding to the category 2, to obtain the 15 pieces of sensing data of the category 2.

It may be understood that the correspondence between the different categories of the sensing data and the different compression schemes is not limited in this application, and the correspondence between the different categories of the sensing data and the different compression schemes may be flexibly configured or adjusted based on a transmission requirement of the sensing data. The compression scheme that can be used may include but is not limited to one or more of the compression scheme based on the 2D indication+the fill value, the compression scheme based on the 2D indication+the geometric structure fitting, the compression scheme based on the 2D indication+the sensing data (or the feature point) compression in the bounding box, the compression scheme for performing quantization compression on the sensing data without sampling, the compression scheme for performing quantization compression on the sensing data with sampling, the compression scheme for performing compression based on the geometric structure corresponding to the sensing data, the compression scheme for performing compression based on the bounding box corresponding to the sensing data, the compression scheme based on geometric projection of the sensing data, and the like.

For example, in the compression scheme for performing quantization compression on the sensing data without sampling, quantization compression without sampling may represent that quantization compression is performed on all data.

In the compression scheme for performing quantization compression on the sensing data with sampling, sampling may be extracting a part of data, for example, extracting a part of data in a form of data downsampling/feature data extraction, and the like, and quantization compression with sampling may represent that quantization compression is performed on the part of extracted data.

In the compression scheme for performing compression based on the geometric structure corresponding to the sensing data, the geometric structure may be a structure, for example, a plane, a curved surface, a polygon, a polyhedron, a cube, a cylinder, or a cone. Specifically, compression may be performed in the following manner: (1) Geometric structure information is used to replace original data, where the compressed data includes the geometric structure information, for example, the original data is replaced with a cylinder, and the compressed data may include a center point, a radius, and a height of the cylinder, or the original data is replaced with a polygon, and the compressed data may include a vertex and the like of the polygon; or (2) data compression is performed based on geometric structure information, where the compressed data may include the geometric structure information and/or sensing data information included in a geometric structure, for example, all/a part of sampled sensing data in a geometric structure scanning area. In addition, it may be understood that entropy encoding, or quantization and entropy encoding may be further performed on the foregoing compressed data, to further reduce a data amount.

In the compression scheme for performing compression based on the bounding box corresponding to the sensing data, the bounding box may be a bounding box of a target (a vehicle/person/object, or the like). Specifically, compression may be performed in the following manner: (1) Bounding box information is used to replace original data, where the compressed data includes the bounding box information, and the bounding box information may be a vertex of the bounding box, or a central location and a length of the bounding box; or (2) data compression is performed based on bounding box information, where the compressed data includes the bounding box information and/or data included in the bounding box, for example, all target data/a part of sampled target data (such as a target feature point and a contour point) in the bounding box. In addition, it may be understood that entropy encoding, or quantization and entropy encoding may be further performed on the foregoing compressed data, to further reduce a data amount. A boundary of quantization may be a data range, or may be a bounding box range.

In the compression scheme based on geometric projection of the sensing data, dimension reduction compression may be performed on data obtained by projecting the sensing data based on spherical coordinates/polar coordinates/Descartes coordinates. For example, two dimensions of the obtained data are used as position information, and remaining dimension data is compressed. This manner may be used for all data/a part of data, may be used for geometric structure information and/or data included in a geometric structure, and may be used for target bounding box information and/or data included in a bounding box.

In some implementations, the second communication apparatus may further send a compression configuration to the first communication apparatus, and the first communication apparatus may further generate and send compressed data based on the compression configuration.

FIG. 13 is a sensing data transmission method 2 according to this application. The method includes the following steps.

S1301: A second communication apparatus sends a compression configuration to a first communication apparatus, and correspondingly, the first communication apparatus receives the compression configuration.

The compression configuration may indicate one or more categories of sensing data to be transmitted, and may further indicate transmission priorities respectively corresponding to the one or more categories of sensing data to be transmitted.

In an example, the compression configuration may indicate, by using an index (or an identifier) of a category, the one or more categories of the sensing data to be transmitted. For example, an index of a category 1 is 1, an index of a category 2 is 2, and an index of a category 3 is 3. For sensing data of the category 2 and sensing data of the category 3 that are required by the second communication apparatus, the index 2 of the category 2 and the index 3 of the category 3 may be carried in first indication information to indicate the first communication apparatus to separately compress and report the sensing data of the category 2 and the sensing data of the category 3.

In addition, the second communication apparatus may further sort indexes of categories that need to be transmitted based on corresponding transmission priorities (or importance degrees), for example, sort the indexes in descending order of the transmission priorities (or the importance degrees), to indicate the transmission priorities corresponding to the categories that need to be transmitted.

It may be understood that the compression configuration may alternatively indicate, in a manner, for example, a bitmap, the category to be transmitted. For example, there are 10 categories of sensing data. The 10 categories one-to-one correspond to 10 bits in the bitmap. If a bit in the bitmap is 1, it indicates that a category corresponding to the bit needs to be transmitted. If a bit in the bitmap is 0, it indicates that a category corresponding to the bit does not need to be transmitted.

In some implementations, the compression configuration may further indicate information such as a compression parameter and/or compression performance respectively corresponding to the one or more categories of the sensing data to be transmitted.

For example, the compression configuration further indicates compression performance (or performance precision) respectively corresponding to the one or more categories of the sensing data to be transmitted. Indexes of different compression performance (or performance precision) may be shown in Table 1. Compression performance respectively corresponding to the one or more categories of the sensing data to be transmitted may be determined by using one or more performance indexes carried in a compression performance field of the compression configuration. For example, the sensing data to be transmitted are of a category 2 and a category 3, and the compression performance field of the compression configuration includes indexes 1 and 2. The first communication apparatus that receives compression configuration information may determine that compression performance corresponding to the category 2 is e-04, and compression performance corresponding to the category 2 is e-05.

**Table 1**

| Compression precision (performance precision) | e-03 | e-04 | e-05 | e-06 | ... |
|---|---|---|---|---|---|
| Category index | 0 | 1 | 2 | 3 | |

In this embodiment of this application, the compression precision (or the performance precision) may be information such as a mean-square error (mean-square error, MSE) between original data and data restored based on compressed data.

The compression parameter may include information such as a quantity of quantization bits, and the quantity of quantization bits refers to a quantity of bits of a binary number required for distinguishing all quantization levels. For example, if there are eight quantization levels, the quantization levels may be distinguished by a three-bit binary number, and quantization precision may be represented as a ratio of a range (that is, a quantization range) of a value that needs to be quantized to a quantity of quantization levels. If a quantization compression scheme is used, a larger quantity of quantization levels indicates higher precision of data restored through decompression. Therefore, a larger quantity of quantization bits indicates higher compression precision (or performance precision). In some implementations, there may be a mapping relationship between the compression precision and the compression parameter (for example, the quantity of quantization bits), and a quantity of applied quantization bits may be determined based on the compression precision.

It should be understood that, in this embodiment of this application, that the second communication apparatus sends the compression configuration to the first communication apparatus is an optional operation. If the second communication apparatus does not send the compression configuration to the first communication apparatus, the first communication apparatus may use a default compression configuration, for example, default transmission priorities of various categories.

S1302: The first communication apparatus generates the compressed data and the first indication information.

Specifically, the first communication apparatus may generate the compressed data and the first indication information based on the compression configuration. For example, the first communication apparatus may compress, in a compression scheme corresponding to each category based on the one or more categories of the sensing data to be transmitted that are indicated by the compression configuration, the category of sensing data to be transmitted, to obtain the compressed data.

If the compression configuration further indicates the information such as the compression parameter and/or the compression performance corresponding to the one or more categories of the sensing data to be transmitted, and the first communication apparatus compresses, in the compression scheme corresponding to each category, the category of sensing data to be transmitted, to obtain the compressed data, a used compression parameter (for example, a quantity of quantization bits) may be determined based on the information such as the compression parameter and/or the compression performance corresponding to the category.

It may be understood that information such as the compression parameter (for example, the quantity of quantization bits) used in a compression scheme corresponding to each category may also be configured by default.

S1303: The first communication apparatus sends the compressed data and the first indication information to the second communication apparatus, and correspondingly, the second communication apparatus receives the compressed data and the first indication information.

For example, the sensing data to be transmitted includes a category 1 (ground), a category 2 (building), a category 3 (vehicle), and a category 4 (other). The first indication information (for example, a 2D mapping diagram may indicate a category of each piece of sensing data). The compressed data may include a quantized compressed parameter and quantized compressed data. For example, in a compression scheme based on a 2D indication+fill value selection for the category 1 (ground), an index of a value of a (which may be defaulted) may be included, and boundaries min and max (quantization ranges) of the value of a+quantized data of the value of a (which may be quantized data of the value of a obtained through compression such as entropy encoding) may be further included; in a compression scheme of a 2D indication+plane fitting for the category 2 (building), plane parameters may be included, and a residual quantization range+residual quantized data may be further included; in a compression scheme of a 2D indication+sampling sensing data (feature points) compression in a bounding box for the category 3 (vehicle), an index of a value of a (which may be defaulted) may be included, and boundaries min and max (quantization ranges) of the value of a+quantized data of the value of a (which may be quantized data of the value of a obtained through compression such as entropy encoding) may be further included; and in a compression scheme of a 2D indication+fill value selection for the category 4 (other), an index of a value of a (which may be defaulted) may be included, and boundaries min and max (quantization ranges) of the value of a+quantized data of the value of a (which may be quantized data of the value of a obtained through compression such as entropy encoding) may be further included.

In addition, if extending a correspondence between another category and a compression scheme, the first communication apparatus may further report information (for example, an index) about the extended category and an index of the corresponding compression scheme to the second communication apparatus. For example, compression scheme indexes 0, 1, 2, 3, 4, and 5 Table 2 respectively represent different compression schemes. If extending a correspondence between a category and a compression scheme in Table 2, the first communication apparatus may report information (for example, an index) of the category and an index of the corresponding compression scheme to the second communication apparatus.

**Table 2**

| Compression scheme | Fill value selection | Plane fitting | | Bounding box-based | | | ... |
|---|---|---|---|---|---|---|---|
| | | Send a residual | Do not send the residual | Send only a bounding box | Bounding box quantization | Feature point in the bounding box | |
| Compression scheme index | 0 | 1 | 2 | 3 | 4 | 5 | |

S1304: The second communication apparatus generates the plurality of pieces of sensing data.

The second communication apparatus may restore the plurality of pieces of sensing data based on the received first indication information and the received compressed data.

In some implementations, when resources are limited, compressed data of a category corresponding to a high transmission priority (or importance) may be preferentially transmitted based on transmission priorities (or importance) corresponding to various categories, and compressed data of a category with a secondary transmission priority (or importance) may be incrementally transmitted; or different transmission resources may be allocated to different categories based on transmission priorities (or importance) corresponding to the different categories, or the like.

In an example, corresponding transmission priorities (or importance) may be configured for various categories in different scenarios. For example, in a barrier avoidance scenario, a transmission priority corresponding to a moving target (such as a vehicle)>a transmission priority corresponding to a building>a transmission priority corresponding to a ground, and compressed data of the moving target is preferentially transmitted. In a map construction scenario, a transmission priority corresponding to a building>a transmission priority corresponding to a ground>a transmission priority corresponding to a moving target (such as a vehicle), and a surrounding background environment is preferentially transmitted.

It may be understood that the transmission priorities (or importance) respectively corresponding to the various categories may be preconfigured in the first communication apparatus, or may be indicated by the second communication apparatus. For example, the second communication apparatus delivers the transmission priorities (or importance) through the compression configuration. This is not limited in this application.

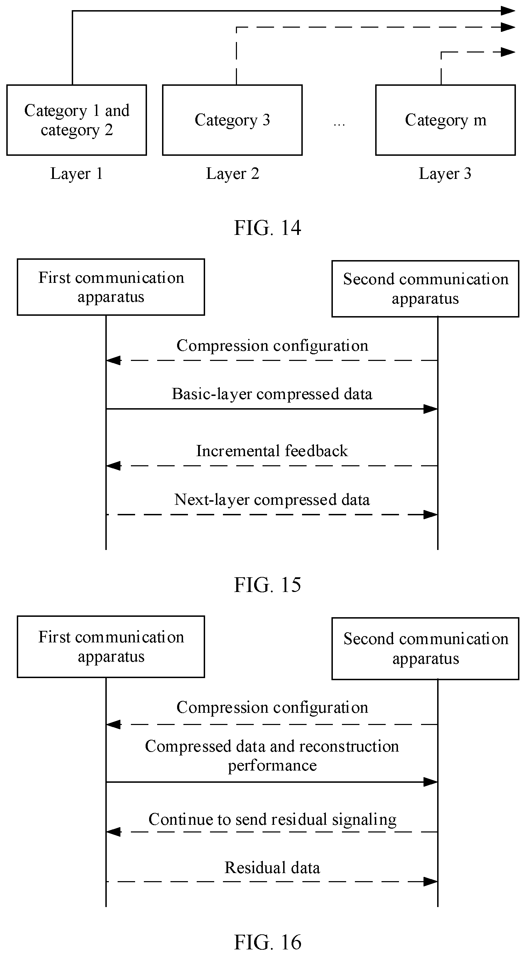

For example, refer to a diagram of layering shown in FIG. 14. A category 1, a category 2, a category 3, ..., and a category m may be classified into a layer 1, a layer 2, and a layer n based on transmission priorities corresponding to the category 1, the category 2, the category 3, ..., and the category m. A transmission priority corresponding to any category at the layer 1 is greater than a transmission priority corresponding to any category at the layer 2. Similarly, a transmission priority corresponding to any category at the layer 2 is greater than a transmission priority corresponding to any category at the layer 3, ..., and a transmission priority corresponding to any category at a layer n-1 is greater than a transmission priority corresponding to any category in the layer n. Refer to a diagram of incremental transmission shown in FIG. 15, the first communication apparatus may first send compressed data corresponding to each category at the layer 1 (a basic layer) to the second communication apparatus, and if receiving an incremental feedback from the second communication apparatus, continue to send compressed data corresponding to each category at a next layer until data transmission is completed or no layer incremental feedback from the second communication apparatus is received. It may be understood that, before or after sending the compressed data corresponding to each category at the layer 1 (the basic layer) to the second communication apparatus, the first communication apparatus may further send the first indication information (for example, the 2D mapping diagram) to the second communication apparatus to indicate a category of each obtained sensing data. Certainly, the first indication information (for example, the 2D mapping diagram) may also be sent together with the compressed data corresponding to each category at the layer 1 (the basic layer). This is not limited in this application.

In some implementations, for a compression scheme based on a 2D indication+plane fitting, an incremental transmission manner may also be used, to reduce a data amount.

Refer to FIG. 16. The first communication apparatus may compress, based on a compression configuration, various categories of sensing data to be transmitted, to obtain various categories of compressed data. For a category of sensing data that exists in a plane form, such as a building, corresponding compressed data may include only plane parameters or plane identification points, and may further include reconstruction performance. The reconstruction performance may be determined based on an error that is between a restored point of the sensing data determined based on the first indication information (for example, the 2D mapping diagram) and the plane parameters (or the plane identification points) and real sensing data. If the reconstruction performance does not meet a reconstruction performance threshold T, the second communication apparatus feeds back, to the second communication apparatus, second indication information (for example, continuing to send residual signaling (or a resource)) that indicates to send residuals corresponding to the plurality of pieces of sensing data. If the reconstruction performance meets a reconstruction performance threshold T, this interaction may be ended. If receiving the second indication information (for example, continuing to send residual signaling), the first communication apparatus may send, to the second communication apparatus, residual data determined based on the real sensing data and the restored data, and the second communication apparatus restores, with high precision based on the residual data, plane-based compressed data.

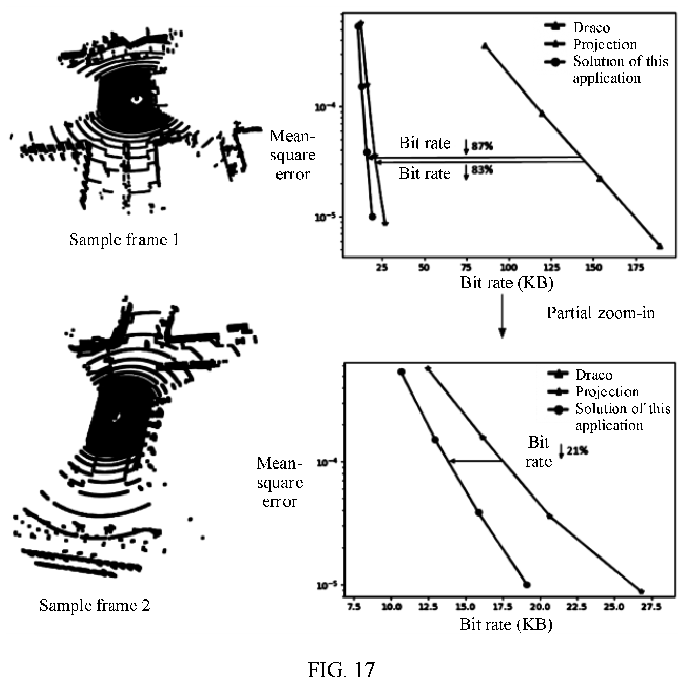

Refer to a diagram 1 of a simulation result of sensing data transmission shown in FIG. 17. FIG. 17 is a diagram of a bit rate (Rate) and a mean-square error (MSE) corresponding to two frames of sensing data samples of two intersection streets in a 360° view of the first communication apparatus. For example, three-dimensional data included in the sensing data is three-dimensional coordinates. In a Draco solution, Kd tree (KDtree) compression is used, and a quantity of quantization bits are 8 to 16. In a projection (projection, Proj) solution, a 2D mapping diagram (two-dimensional data)+an R distance sequence (third-dimensional data) are used, where quantization compression is performed on the R distance sequence according to an LZMA compression algorithm (a quantity of quantization bits are 8 to 13).

The solution of this application may also be referred to as a classification-based sensing data compression scheme (Proj class-based compression). For example, four categories are obtained through classification: ground: a 2D mapping diagram (two-dimensional data)+a z-value sequence (third-dimensional data), where quantization compression is performed on the z-value sequence according to the LZMA compression algorithm (the quantity of quantization bits are 8 to 13); building: a 2D mapping diagram (two-dimensional data)+plane-based compression (plane parameters or plane identification points under low precision or parameters or plane identification points under high precision+a residual); vehicle: a 2D mapping diagram (two-dimensional data)+an r-value sequence in which odd-numbered locations in the 2D mapping diagram are as feature points, where quantization compression is performed on the r-value sequence according to the LZMA compression algorithm (the quantity of quantization bits are 8 to 13), and values of r at even-numbered locations are obtained by performing linear interpolation on the values of r restored at the odd-numbered locations; and other (a utility pole, vegetation, and the like): a 2D mapping diagram (two-dimensional data)+an r-value sequence (third-dimensional data), where quantization compression is performed on the r-value sequence according to the LZMA compression algorithm (the quantity of quantization bits are 8 to 13). It can be learned from FIG. 17 that, when the solution of this application is applied to transmit the sensing data, a data amount (a bit rate) decreases significantly.

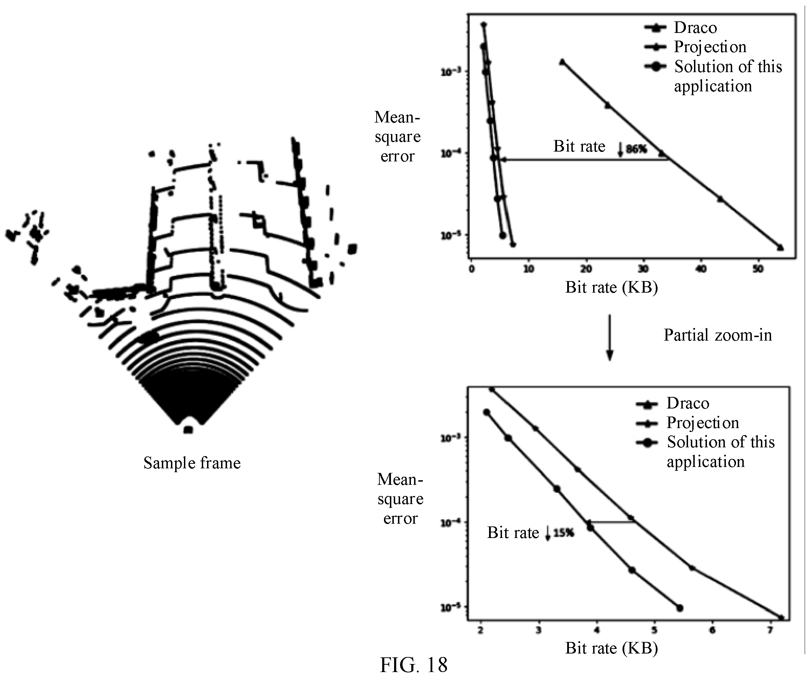

Refer to a diagram of a simulation result of sensing data transmission shown in FIG. 18. FIG. 18 is a diagram of a corresponding bit rate (Rate) and a corresponding mean-square error (MSE) obtained by averaging 24 frames of sensing data samples of two intersection streets in a 120° view of the first communication apparatus. It can be learned that when the solution of this application is applied to transmit the sensing data, a data amount (bit rate) also significantly decreases.

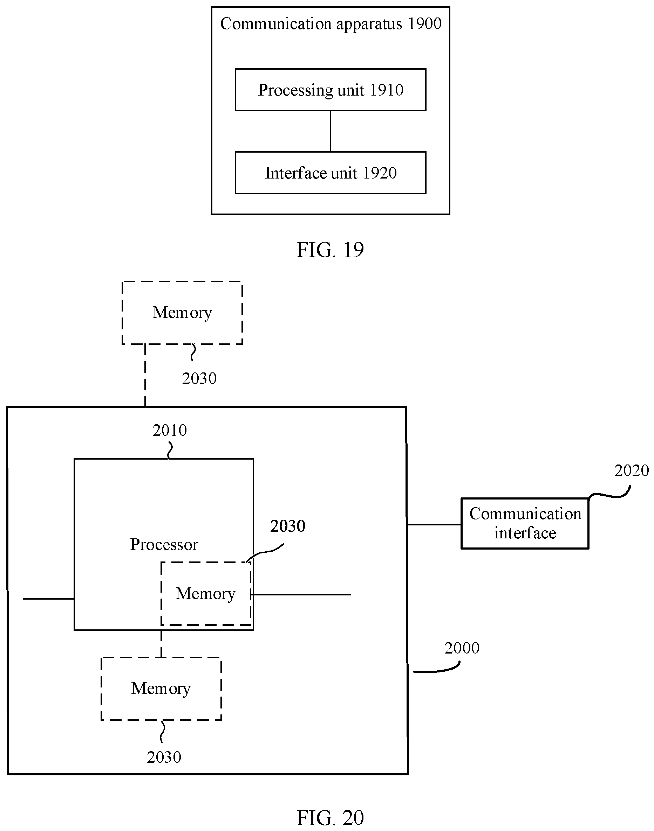

The following describes a communication apparatus provided in embodiments of this application. FIG. 19 is a diagram of a structure of the communication apparatus according to an embodiment of this application. The communication apparatus may include units or modules corresponding to all or a part of the steps in the foregoing method embodiments, and may be configured to perform the steps performed by the first communication apparatus or the second communication apparatus in the foregoing embodiments. For details, refer to related descriptions in the foregoing method embodiments.

As shown in FIG. 19, a communication apparatus 1900 includes a processing unit 1910 and an interface unit 1920. The processing unit 1910 may be a processor or a processing circuit, and the interface unit 1920 may further be a transceiver unit or an input/output interface. The communication apparatus 1900 may be configured to implement the steps performed by the first communication apparatus or the second communication apparatus in the foregoing embodiments.

When the communication apparatus 1900 is configured to implement the steps performed by the first communication apparatus in the foregoing embodiments,
the processing unit 1910 is configured to generate compressed data and first indication information, where the first indication information indicates categories of a plurality of pieces of sensing data, the compressed data is obtained by compressing the plurality of pieces of sensing data according to compression schemes corresponding to the categories of the plurality of pieces of sensing data, and sensing data of a same category among the plurality of pieces of sensing data corresponds to a same compression scheme in a correspondence between different categories of sensing data and different compression schemes; and the interface unit 1920 is configured to send the compressed data and the first indication information to a second communication apparatus.

For example, the categories of the plurality of pieces of sensing data are determined based on categories of target objects corresponding to the plurality of pieces of sensing data.

In a possible design, the correspondence between the different categories of the sensing data and the different compression schemes includes: one or more of a compression scheme for performing quantization compression on sensing data without sampling; a compression scheme for performing quantization compression on sensing data with sampling; a compression scheme for performing compression based on a geometric structure corresponding to sensing data; a compression scheme for performing compression based on a bounding box corresponding to sensing data; or a compression scheme based on geometric projection of sensing data.

In a possible design, any piece of sensing data includes multi-dimensional data, the first indication information further indicates position information of the plurality of pieces of sensing data, and position information of any piece of sensing data is determined based on two-dimensional data in the multi-dimensional data in the sensing data.

In a possible design, the plurality of pieces of sensing data are of a first category, and the processing unit 1910 is specifically configured to: when generating the compressed data, perform quantization compression on third-dimensional data of the plurality of pieces of sensing data, to obtain a quantization range and quantized compressed data, where third-dimensional data of any piece of sensing data is data in the multi-dimensional data in the sensing data other than the two-dimensional data that corresponds to the position information.

In a possible design, the multi-dimensional data in any piece of sensing data includes at least three of θ, φ, R, x, y, z, r, θ represents a vertical angle in a spherical coordinate system, φ represents a horizontal angle in the spherical coordinate system, x represents an abscissa in a Cartesian coordinate system, y represents an ordinate in the Cartesian coordinate system, z represents a vertical coordinate in the Cartesian coordinate system, r represents a projected distance on a horizontal plane in the Cartesian coordinate system, R represents a distance to an origin in the spherical coordinate system, and the third-dimensional data in the plurality of pieces of sensing data other than the two-dimensional data that corresponds to the position information is selected based on an information entropy or a value range of each dimension of data in the multi-dimensional data other than the two-dimensional data.

In a possible design, the plurality of pieces of sensing data are of a second category, and the processing unit 1910 is specifically configured to: when generating the compressed data, determine, based on the plurality of pieces of sensing data, geometric structure parameters or geometric structure identification points of at least one geometric structure in which the plurality of pieces of sensing data are located, where the first indication information further indicates a geometric structure in which the plurality of pieces of sensing data are located, and geometric structure parameters or geometric structure identification points of any geometric structure are used to determine the geometric structure.

In a possible design, the processing unit 1910 is further configured to perform quantization compression on residuals corresponding to the plurality of pieces of sensing data to obtain quantized compressed data, where the residuals corresponding to the plurality of pieces of sensing data are determined based on the plurality of pieces of sensing data and a plurality of pieces of restored data corresponding to the plurality of pieces of sensing data, and restored data corresponding to any piece of sensing data is determined based on position information of the sensing data and a geometric structure in which the sensing data is located.

In a possible design, the plurality of pieces of sensing data are of a third category, and the processing unit 1910 is specifically configured to: when generating the compressed data, determine at least one bounding box corresponding to the plurality of pieces of sensing data, where the first indication information further indicates a bounding box in which the plurality of pieces of sensing data are located; and perform quantization compression on bounding box endpoints of the plurality of pieces of sensing data and/or sensing data located at the bounding box endpoints to obtain quantized compressed data; or perform quantization compression on third-dimensional data of a plurality of pieces of sensing data located in any bounding box to obtain quantized compressed data, where third-dimensional data of any piece of sensing data is data in the multi-dimensional data in the sensing data other than the two-dimensional data that corresponds to the position information.

In a possible design, the processing unit 1910 is specifically configured to: when performing quantization compression on the third-dimensional data of the plurality of pieces of sensing data located in any bounding box, to obtain the quantized compressed data, perform quantization compression on third-dimensional data of all the sensing data located in the bounding box to obtain quantized compressed data; or perform quantization compression on the bounding box endpoints of the plurality of pieces of sensing data and/or third-dimensional data of the sensing data located at the bounding box endpoints to obtain quantized compressed data; or perform quantization compression on third-dimensional data of a plurality of pieces of sampled sensing data among the plurality of pieces of sensing data to obtain quantized compressed data, where a quantity of the plurality of pieces of sampled sensing data is less than a quantity of the plurality of pieces of sensing data.

In a possible design, the interface unit 1920 is further configured to receive a compression configuration from the second communication apparatus, where the compression configuration indicates one or more categories of sensing data to be transmitted, and the categories of the plurality of pieces of sensing data belong to the categories of the sensing data to be transmitted that are indicated by the compression configuration.

In a possible design, the compression configuration further indicates a compression parameter and/or compression performance respectively corresponding to the one or more categories of sensing data to be transmitted, where the compressed data meets a requirement of the compression parameter and/or the compression performance.

In a possible design, the compression configuration further indicates transmission priorities respectively corresponding to the one or more categories of the sensing data to be transmitted, and the compressed data and the first indication information are sent to the second communication apparatus based on transmission priorities corresponding to the categories of the plurality of pieces of sensing data.

In a possible design, the compressed data further includes reconstruction performance of the plurality of pieces of sensing data, and the interface unit 1920 is further configured to receive second indication information from the second communication apparatus, where the second indication information indicates to send residuals corresponding to the plurality of pieces of sensing data, and the second indication information is sent by the second communication apparatus when the reconstruction performance does not meet a reconstruction performance threshold; and send the residuals corresponding to the plurality of pieces of sensing data to the second communication apparatus, where the residuals corresponding to the plurality of pieces of sensing data are determined based on the plurality of pieces of sensing data and a plurality of pieces of restored data corresponding to the plurality of pieces of sensing data, and restored data corresponding to any piece of sensing data is determined based on position information corresponding to the sensing data and a geometric structure in which the sensing data is located.

When the communication apparatus 1900 is configured to implement the steps performed by the second communication apparatus in the foregoing embodiments,
the interface unit 1920 is configured to receive compressed data and first indication information from a first communication apparatus, where the first indication information indicates categories of a plurality of pieces of sensing data, the compressed data is obtained by compressing the plurality of pieces of sensing data according to compression schemes corresponding to the categories of the plurality of pieces of sensing data; and the processing unit 1910 is configured to generate the plurality of pieces of sensing data, where the plurality of pieces of sensing data are obtained by decompressing the compressed data in decompression schemes corresponding to the categories of the plurality of pieces of sensing data, and sensing data of a same category among the plurality of pieces of sensing data corresponds to a same decompression scheme in a correspondence between different categories of sensing data and different decompression schemes.

For example, the categories of the plurality of pieces of sensing data are determined based on categories of target objects corresponding to the plurality of pieces of sensing data.

In a possible design, the correspondence between the different categories of the sensing data and different compression schemes includes: one or more of a compression scheme for performing quantization compression on sensing data without sampling; a compression scheme for performing quantization compression on sensing data with sampling; a compression scheme for performing compression based on a geometric structure corresponding to sensing data; a compression scheme for performing compression based on a bounding box corresponding to sensing data; or a compression scheme based on geometric projection of sensing data.

In a possible design, any piece of sensing data includes multi-dimensional data, the first indication information further indicates position information of the plurality of pieces of sensing data, and position information of any piece of sensing data is determined based on two-dimensional data in the multi-dimensional data in the sensing data; and the plurality of pieces of sensing data are obtained by decompressing the compressed data based on the decompression schemes corresponding to the categories of the plurality of pieces of sensing data and the position information of the plurality of pieces of sensing data.

In a possible design, the plurality of pieces of sensing data are of a first category, the compressed data includes quantized compressed data obtained by performing quantization compression on third-dimensional data of the plurality of pieces of sensing data, and third-dimensional data of any piece of sensing data is data in the multi-dimensional data in the sensing data other than the two-dimensional data that corresponds to the position information.

In a possible design, the plurality of pieces of sensing data are of a second category, the compressed data includes geometric structure parameters or geometric structure identification points of at least one geometric structure in which the plurality of pieces of sensing data are located, and the first indication information further indicates a geometric structure in which the plurality of pieces of sensing data are located, and geometric structure parameters or geometric structure identification points of any geometric structure are used to determine the geometric structure.

In a possible design, the compressed data further includes quantized compressed data obtained by performing quantization compression on residuals corresponding to the plurality of pieces of sensing data, where the residuals corresponding to the plurality of pieces of sensing data are determined based on the plurality of pieces of sensing data and a plurality of pieces of restored data corresponding to the plurality of pieces of sensing data, and restored data corresponding to any piece of sensing data is determined based on position information corresponding to the sensing data and a geometric structure in which the sensing data is located.

In a possible design, the plurality of pieces of sensing data are of a third category, the first indication information further indicates a bounding box in which the plurality of pieces of sensing data are located, the compressed data includes quantized compressed data obtained by performing quantization compression on bounding box endpoints of the plurality of pieces of sensing data and/or sensing data located at the bounding box endpoints or quantized compressed data obtained by performing quantization compression on third-dimensional data of a plurality of pieces of sensing data located in any bounding box indicated by the first indication information, and third-dimensional data of any piece of sensing data is data in the multi-dimensional data in the sensing data other than the two-dimensional data that corresponds to the position information.

In a possible design, the quantized compressed data obtained by performing quantization compression on the third-dimensional data of the plurality of pieces of sensing data located in any bounding box includes: quantized compressed data obtained by performing quantization compression on third-dimensional data of all the sensing data located in the bounding box; or quantized compressed data obtained by performing quantization compression on the bounding box endpoints of the plurality of pieces of sensing data and/or third-dimensional data of the bounding box endpoints; or quantized compressed data obtained by performing quantization compression on third-dimensional data of a plurality of pieces of sampled sensing data among the plurality of pieces of sensing data, and a quantity of the plurality of pieces of sampled sensing data is less than a quantity of the plurality of pieces of sensing data.

In a possible design, the interface unit 1920 is further configured to send a compression configuration to the first communication apparatus, where the compression configuration indicates one or more categories of sensing data to be transmitted, and the categories of the plurality of pieces of sensing data belong to the categories of the sensing data to be transmitted that are indicated by the compression configuration.

In a possible design, the compression configuration further indicates a compression parameter and/or compression performance respectively corresponding to the one or more categories of sensing data to be transmitted, where the compressed data meets a requirement of the compression parameter and/or the compression performance.

In a possible design, the compression configuration further indicates transmission priorities respectively corresponding to the one or more categories of the sensing data to be transmitted.

In a possible design, the compressed data further includes reconstruction performance of the plurality of pieces of sensing data, and the interface unit 1920 is further configured to send second indication information to the first communication apparatus when the reconstruction performance does not meet a reconstruction performance threshold, where the second indication information indicates to send residuals corresponding to the plurality of pieces of sensing data; and receive the residuals corresponding to the plurality of pieces of sensing data from the first communication apparatus, where the residuals corresponding to the plurality of pieces of sensing data are determined based on the plurality of pieces of sensing data and a plurality of pieces of restored data corresponding to the plurality of pieces of sensing data, and restored data corresponding to any piece of sensing data is determined based on position information corresponding to the sensing data and a geometric structure in which the sensing data is located.

As shown in FIG. 20, this application further provides a communication apparatus 2000, including a processor 2010 and further including a communication interface 2020. The processor 2010 and the communication interface 2020 are coupled to each other. It may be understood that the communication interface 2020 may be a transceiver, an input/output interface, an input interface, an output interface, an interface circuit, or the like. Optionally, the communication apparatus 2000 may further include a memory 2030, configured to: store instructions executed by the processor 2010 or store input data required for running instructions by the processor 2010 or store data generated after the processor 2010 runs instructions. The memory 2030 may be a physically independent unit, or may be coupled to the processor 2010, or the processor 2010 includes the memory 2030.

When the communication apparatus 2000 is configured to implement the steps performed by the first communication apparatus and the second communication apparatus in the foregoing embodiments, the processor 2010 may be configured to implement a function of the processing unit 1910, and the communication interface 2020 may be configured to implement a function of the interface unit 1920.

It should be noted that the processor in embodiments of this application may be a central processing unit (central processing unit, CPU), or may be another general-purpose processor, a digital signal processor (digital signal processor, DSP), an application-specific integrated circuit (application specific integrated circuit, ASIC), a logical circuit, a field programmable gate array (field programmable gate array, FPGA), or another programmable logic device, a transistor logic device, a hardware component, or any combination thereof. The general-purpose processor may be a microprocessor or any regular processor or the like.

The method steps in embodiments of this application may be implemented in a hardware manner, or may be implemented in a manner of executing software instructions by the processor. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk, a removable hard disk, a CD-ROM, or any other form of storage medium well-known in the art. For example, a storage medium is coupled to a processor, so that the processor can read information from the storage medium and write information into the storage medium. Certainly, the storage medium may be a component of the processor. The processor and the storage medium may be disposed in an ASIC. In addition, the ASIC may be located in a network device or a terminal device. Certainly, the processor and the storage medium may alternatively exist as discrete components in a network device or a terminal device.

All or a part of the foregoing embodiments may be implemented by using software, hardware, firmware, or any combination thereof. When software is used to implement the embodiments, all or a part of the embodiments may be implemented in a form of a computer program product. The computer program product includes one or more computer programs or instructions. When the computer programs or instructions are loaded and executed on a computer, the procedures or functions in embodiments of this application are all or partially executed. The computer may be a general-purpose computer, a dedicated computer, a computer network, a network device, user equipment, or another programmable apparatus. The computer program or instructions may be stored in a computer-readable storage medium, or transmitted from one computer-readable storage medium to another computer-readable storage medium. For example, the computer program or instructions may be transmitted from one network device, terminal, computer, server, or data center to another network device, terminal, computer, server, or data center in a wired or wireless manner. The computer-readable storage medium may be any usable medium that can be accessed by the computer, or a data storage device, for example, a server or a data center, integrating one or more usable media. The usable medium may be a magnetic medium, for example, a floppy disk, a hard disk, or a magnetic tape; or may be an optical medium, for example, a digital video disc; or may be a semiconductor medium, for example, a solid-state drive. The computer-readable storage medium may be a volatile or non-volatile storage medium, or may include two types of storage media: a volatile storage medium and a non-volatile storage medium.

In embodiments of this application, unless otherwise stated or there is a logic conflict, terms and/or descriptions in different embodiments are consistent and may be mutually referenced, and technical features in different embodiments may be combined into a new embodiment based on an internal logical relationship thereof.

In addition, it should be understood that the term "for example" in embodiments of this application is used to represent giving an example, an illustration, or a description. Any embodiment or design scheme described as an "example" in this application should not be explained as being more preferred or having more advantages than another embodiment or design scheme. Exactly, the term "example" is for presenting a concept in a specific manner.

It may be understood that various numbers in embodiments of this application are merely used for differentiation for ease of description, and are not used to limit the scope of embodiments of this application. Sequence numbers of the foregoing processes do not mean an execution sequence, and the execution sequence of the processes should be determined based on functions and internal logic of the processes.

## Claims

1. A sensing data transmission method, applied to a first communication apparatus, and comprising:
generating compressed data and first indication information, wherein the first indication information indicates categories of a plurality of pieces of sensing data, the compressed data is obtained by compressing the plurality of pieces of sensing data according to compression schemes corresponding to the categories of the plurality of pieces of sensing data, and sensing data of a same category among the plurality of pieces of sensing data corresponds to a same compression scheme in a correspondence between different categories of sensing data and different compression schemes; and
sending the compressed data and the first indication information to a second communication apparatus.

2. The method according to claim 1, wherein the categories of the plurality of pieces of sensing data are determined based on categories of target objects corresponding to the plurality of pieces of sensing data.

3. The method according to claim 1 or 2, wherein the correspondence between the different categories of the sensing data and the different compression schemes comprise at least one of the following compression schemes:
a compression scheme for performing quantization compression on sensing data without sampling;
a compression scheme for performing quantization compression on sensing data with sampling;
a compression scheme for performing compression based on a geometric structure corresponding to sensing data;
a compression scheme for performing compression based on a bounding box corresponding to sensing data; or
a compression scheme based on geometric projection of sensing data.

4. The method according to claim 1 or 2, wherein any piece of sensing data comprises multi-dimensional data, the first indication information further indicates position information of the plurality of pieces of sensing data, and position information of any piece of sensing data is determined based on two-dimensional data in the multi-dimensional data in the sensing data.

5. The method according to claim 4, wherein the plurality of pieces of sensing data are of a first category; and generating the compressed data comprises:
performing quantization compression on third-dimensional data of the plurality of pieces of sensing data to obtain quantized compressed data, wherein third-dimensional data of any piece of sensing data is data in the multi-dimensional data in the sensing data other than the two-dimensional data that corresponds to the position information.

6. The method according to claim 5, wherein the multi-dimensional data in any piece of sensing data comprises at least three of θ, φ, R, x, y, z, r, θ represents a vertical angle in a spherical coordinate system, φ represents a horizontal angle in the spherical coordinate system, R represents a distance to an origin in the spherical coordinate system, x represents an abscissa in a Cartesian coordinate system, y represents an ordinate in the Cartesian coordinate system, z represents a vertical coordinate in the Cartesian coordinate system, r represents a projected distance on a horizontal plane in the Cartesian coordinate system, and the third-dimensional data in the plurality of pieces of sensing data other than the two-dimensional data that corresponds to the position information is selected based on an information entropy or a value range of each dimension of data in the multi-dimensional data other than the two-dimensional data.

7. The method according to claim 4, wherein the plurality of pieces of sensing data are of a second category; and generating the compressed data comprises:
determining, based on the plurality of pieces of sensing data, geometric structure parameters or geometric structure identification points of at least one geometric structure in which the plurality of pieces of sensing data are located, wherein the first indication information further indicates a geometric structure in which the plurality of pieces of sensing data are located, and geometric structure parameters or geometric structure identification points of any geometric structure are used to determine the geometric structure.

8. The method according to claim 7, wherein the method further comprises:
performing quantization compression on residuals corresponding to the plurality of pieces of sensing data to obtain quantized compressed data, wherein the residuals corresponding to the plurality of pieces of sensing data are determined based on the plurality of pieces of sensing data and a plurality of pieces of restored data corresponding to the plurality of pieces of sensing data, and restored data corresponding to any piece of sensing data is determined based on the position information of the sensing data and a geometric structure in which the sensing data is located.

9. The method according to claim 4, wherein the plurality of pieces of sensing data are of a third category; and generating the compressed data comprises:
determining at least one bounding box corresponding to the plurality of pieces of sensing data, wherein the first indication information further indicates the bounding box in which the plurality of pieces of sensing data are located; and
performing quantization compression on bounding box endpoints of the plurality of pieces of sensing data and/or sensing data located at the bounding box endpoints to obtain quantized compressed data; or
performing quantization compression on third-dimensional data of a plurality of pieces of sensing data located in any bounding box to obtain quantized compressed data, wherein third-dimensional data of any piece of sensing data is data in the multi-dimensional data in the sensing data other than the two-dimensional data that corresponds to the position information.

10. The method according to claim 9, wherein performing quantization compression on the third-dimensional data of the plurality of pieces of sensing data located in any bounding box to obtain the quantized compressed data comprises:
performing quantization compression on third-dimensional data of all the sensing data located in the bounding box to obtain quantized compressed data; or
performing quantization compression on the bounding box endpoints of the plurality of pieces of sensing data and/or third-dimensional data of the sensing data located at the bounding box endpoints to obtain quantized compressed data; or
performing quantization compression on third-dimensional data of a plurality of pieces of sampled sensing data among the plurality of pieces of sensing data to obtain quantized compressed data, wherein a quantity of the plurality of pieces of sampled sensing data is less than a quantity of the plurality of pieces of sensing data.

11. The method according to any one of claims 1 to 10, wherein the method further comprises:
receiving a compression configuration from the second communication apparatus, wherein the compression configuration indicates one or more categories of sensing data to be transmitted, and a compression parameter and/or compression performance respectively corresponding to the one or more categories of the sensing data to be transmitted, the categories of the plurality of pieces of sensing data belong to the categories of the sensing data to be transmitted that are indicated by the compression configuration, and the compressed data meets a requirement of the compression parameter and/or the compression performance.

12. The method according to claim 11, wherein the compression configuration further indicates transmission priorities respectively corresponding to the one or more categories of the sensing data to be transmitted, and the compressed data and the first indication information are sent to the second communication apparatus based on transmission priorities corresponding to the categories of the plurality of pieces of sensing data.

13. The method according to claim 7, wherein the compressed data further comprises reconstruction performance of the plurality of pieces of sensing data; and the method further comprises:
receiving second indication information from the second communication apparatus, wherein the second indication information indicates to send residuals corresponding to the plurality of pieces of sensing data, and the second indication information is sent by the second communication apparatus when the reconstruction performance does not meet a reconstruction performance threshold; and
sending the residuals corresponding to the plurality of pieces of sensing data to the second communication apparatus, wherein the residuals corresponding to the plurality of pieces of sensing data are determined based on the plurality of pieces of sensing data and a plurality of pieces of restored data corresponding to the plurality of pieces of sensing data, and restored data corresponding to any piece of sensing data is determined based on position information of the sensing data and a geometric structure in which the sensing data is located.

14. A sensing data transmission method, applied to a second communication apparatus, and comprising:
receiving compressed data and first indication information from a first communication apparatus, wherein the first indication information indicates categories of a plurality of pieces of sensing data, and the compressed data is obtained by compressing the plurality of pieces of sensing data according to compression schemes corresponding to the categories of the plurality of pieces of sensing data; and
generating the plurality of pieces of sensing data, wherein the plurality of pieces of sensing data are obtained by decompressing the compressed data in decompression schemes corresponding to the categories of the plurality of pieces of sensing data, and sensing data of a same category among the plurality of pieces of sensing data corresponds to a same decompression scheme in a correspondence between different categories of sensing data and different decompression schemes.

15. The method according to claim 14, wherein the categories of the plurality of pieces of sensing data are determined based on categories of target objects corresponding to the plurality of pieces of sensing data.

16. The method according to claim 14 or 15, wherein a correspondence between the different categories of sensing data and different compression schemes comprise at least one of the following compression schemes:
a compression scheme for performing quantization compression on sensing data without sampling;
a compression scheme for performing quantization compression on sensing data with sampling;
a compression scheme based on a geometric structure corresponding to sensing data;
a compression scheme based on a bounding box corresponding to sensing data; or
a compression scheme based on geometric projection of sensing data.

17. The method according to claim 14 or 15, wherein any piece of sensing data comprises multi-dimensional data, the first indication information further indicates position information of the plurality of pieces of sensing data, and position information of any piece of sensing data is determined based on two-dimensional data in the multi-dimensional data in the sensing data; and
the plurality of pieces of sensing data are obtained by decompressing the compressed data based on the decompression schemes corresponding to the categories of the plurality of pieces of sensing data and the position information of the plurality of pieces of sensing data.

18. The method according to claim 17, wherein the plurality of pieces of sensing data are of a first category, the compressed data comprises quantized compressed data obtained by performing quantization compression on third-dimensional data of the plurality of pieces of sensing data, and third-dimensional data of any piece of sensing data is data in the multi-dimensional data in the sensing data other than the two-dimensional data that corresponds to the position information.

19. The method according to claim 17, wherein the plurality of pieces of sensing data are of a second category, the compressed data comprises geometric structure parameters or geometric structure identification points of at least one geometric structure in which the plurality of pieces of sensing data are located, and the first indication information further indicates a geometric structure in which the plurality of pieces of sensing data are located, and geometric structure parameters or geometric structure identification points of any geometric structure are used to determine the geometric structure.

20. The method according to claim 19, wherein the compressed data further comprises quantized compressed data obtained by performing quantization compression on residuals corresponding to the plurality of pieces of sensing data, the residuals corresponding to the plurality of pieces of sensing data are determined based on the plurality of pieces of sensing data and a plurality of pieces of restored data corresponding to the plurality of pieces of sensing data, and restored data corresponding to any piece of sensing data is determined based on position information of the sensing data and a geometric structure in which the sensing data is located.

21. The method according to claim 17, wherein the plurality of pieces of sensing data are of a third category, the first indication information further indicates a bounding box in which the plurality of pieces of sensing data are located, the compressed data comprises quantized compressed data obtained by performing quantization compression on bounding box endpoints of the plurality of pieces of sensing data and/or sensing data located at the bounding box endpoints or quantized compressed data obtained by performing quantization compression on third-dimensional data of a plurality of pieces of sensing data located in any bounding box indicated by the first indication information, and third-dimensional data of any piece of sensing data is data in the multi-dimensional data in the sensing data other than the two-dimensional data that corresponds to the position information.

22. The method according to claim 21, wherein the quantized compressed data obtained by performing quantization compression on the third-dimensional data of the plurality of pieces of sensing data located in any bounding box comprises:
quantized compressed data obtained by performing quantization compression on third-dimensional data of all the sensing data located in the bounding box; or
quantized compressed data obtained by performing quantization compression on the bounding box endpoints of the plurality of pieces of sensing data and/or third-dimensional data of the sensing data located at the bounding box endpoints; or
quantized compressed data obtained by performing quantization compression on third-dimensional data of a plurality of pieces of sampled sensing data among the plurality of pieces of sensing data, and a quantity of the plurality of pieces of sampled sensing data is less than a quantity of the plurality of pieces of sensing data.

23. The method according to any one of claims 14 to 22, wherein the method further comprises:
sending a compression configuration to the first communication apparatus, wherein the compression configuration indicates one or more categories of sensing data to be transmitted, and a compression parameter and/or compression performance respectively corresponding to the one or more categories of the sensing data to be transmitted, the categories of the plurality of pieces of sensing data belong to the categories of the sensing data to be transmitted that are indicated by the compression configuration, and the compressed data meets a requirement of the compression parameter and/or the compression performance.

24. The method according to claim 23, wherein the compression configuration further indicates transmission priorities respectively corresponding to the one or more categories of the sensing data to be transmitted.

25. The method according to claim 19, wherein the compressed data further comprises reconstruction performance of the plurality of pieces of sensing data; and the method further comprises:
sending second indication information to the first communication apparatus when the reconstruction performance does not meet a reconstruction performance threshold, wherein the second indication information indicates to send residuals corresponding to the plurality of pieces of sensing data; and
receiving the residuals corresponding to the plurality of pieces of sensing data from the first communication apparatus, wherein the residuals corresponding to the plurality of pieces of sensing data are determined based on the plurality of pieces of sensing data and a plurality of pieces of restored data corresponding to the plurality of pieces of sensing data, and restored data corresponding to any piece of sensing data is determined based on position information of the sensing data and a geometric structure in which the sensing data is located.

26. A communication apparatus, comprising a module or a unit configured to perform the method according to any one of claims 1 to 25.

27. A communication apparatus, comprising a processor and an interface circuit, wherein the interface circuit is configured to: receive a signal from a communication apparatus other than the communication apparatus and transmit the signal to the processor, or send a signal from the processor to a communication apparatus other than the communication apparatus, and the processor is configured to perform the method according to any one of claims 1 to 25 by using a logic circuit or by executing instructions.

28. A computer program product, comprising a computer program or instructions, wherein when the computer program or the instructions are executed by a processor, the method according to any one of claims 1 to 25 is implemented.

29. A computer-readable storage medium, wherein the storage medium stores a computer program or instructions, and when the computer program or the instructions are executed by a processor, the method according to any one of claims 1 to 25 is implemented.

30. A communication system, wherein the communication system comprises a first communication apparatus and a second communication apparatus;
the first communication apparatus is configured to implement the method according to any one of claims 1 to 13; and
the second communication apparatus is configured to implement the method according to any one of claims 14 to 25.
